# EUROPEAN PATENT APPLICATION

(11) **EP 4 657 488 A2**
(43) Date of publication of application: **03.12.2025**
(21) Application number: 25175633.4
(22) Date of filing: 12.05.2025
(51) Int. Cl.: H01J 37/04, H01J 37/22

(54) **TECHNIQUES FOR SYNCHRONIZING AND INTERROGATING PARTICLE BEAMS**

(30) Priority: 10.05.2024 US 202463645747 P
(71) Applicant: FEI COMPANY, Hillsboro, OR 97124 (US)
(72) Inventor: BONGIOVANNI, Gabriele, Eindhoven (NL); KIEFT, Erik, Eindhoven (NL)
(74) Representative: Boult Wade Tennant LLP

(57) **Abstract**

A method for characterization of a light beam within a charged particle column, the method comprising: directing a light beam pulse towards a sample within the charged particle column; directing a charged particle beam pulse towards the sample; detecting charged particles that, based at least in part on the light beam pulse and the charged particle beam pulse, interacted with the sample; determining a time delay between the charged particle beam pulse and the light beam pulse based at least in part on the charged particles; and determining at least one characteristic of the light beam pulse based at least in part on the time delay.

## Description

### CROSS-REFERENCE TO RELATED APPLICATION

The present application claims the benefit of priority to U.S. Provisional Application No. 63/645,747, filed May 10, 2024, the entire contents of which are incorporated by reference herein for all purposes.

### TECHNICAL FIELD

Embodiments of the present disclosure are directed to charged particle microscope systems. More particularly, the present disclosure describes beam synchronization techniques in charged particle microscopy.

### BACKGROUND

Charged particle microscopy may be used for studying materials and structures that may be either biological or inorganic in nature. Scanning and transmission electron microscopes (SEM)/(TEM) form images by focusing a beam of electrons and/or photons onto a target such as a protein or a semiconductor wafer. Some particles may interact with the target and relay information about the target to a user of the microscope. Some microscopy techniques may additionally use laser-based techniques in conjunction with charged particle beams. When using laser based-techniques, relaxation time properties of the photoemitter, saturation effects, and residual emission are typically addressed by beam chopping methods. Using a chopper/beam blanker in the TEM, in turn, implicates active synchronization between two sources (the pump and the probe) that inherently each have their own clocks. Synchronization at the picosecond timescale presents significant challenges.

### BRIEF SUMMARY

According to certain embodiments, a method for characterization of a light beam within a charged particle column, the method comprising: directing a light beam pulse towards a sample within the charged particle column; directing a charged particle beam pulse towards the sample; detecting charged particles that, based at least in part on the light beam pulse and the charged particle beam pulse, interacted with the sample; determining a time delay between the charged particle beam pulse and the light beam pulse based at least in part on the charged particles; and determining at least one characteristic of the light beam pulse based at least in part on the time delay.

According to some embodiments, the charged particle beam is a charged particle beam pulse, wherein the light beam is a light beam pulse, and wherein determining the time delay further comprises: synchronizing the charged particle beam pulse with the light beam pulse; and determining a plurality of timesteps, wherein a timestep of the plurality of timesteps represents a temporal offset of the charged particle beam pulse relative to the light beam pulse.

According to some embodiments, the light beam is a light beam pulse, and wherein determining the time delay further comprises: synchronizing the charged particle beam pulse with the light beam pulse; and determining a plurality of timesteps, wherein a timestep of the plurality of timesteps represents a phase delay of the charged particle beam pulse relative to the light beam pulse.

According to some embodiments, the light beam is a light beam pulse including a temporal pulse profile, the method further comprising: directing the charged particle beam into an energy-dispersive spectrometer configured to generate detector data describing an energy distribution of the charged particle beam; generating a set of detector data describing a plurality of energy distributions for a corresponding plurality of time steps; generating profile data using the set of detector data, the profile data describing the temporal pulse profile.

According to some embodiments, generating the set of detector data comprises sampling detector data generated concurrent with a period of interaction of the light beam and the charged particle beam, wherein the detector data is characterized by a sampling period about an order of magnitude smaller than a pulse duration described by the at least one characteristic, the at least one characteristic being the temporal pulse profile of an intensity of the light beam.

According to some embodiments, the charged particle beam is a charged particle beam pulse, and wherein generating the set of detector data comprises integrating detector data for a given time step using multiple pulses of charged particles.

According to some embodiments, generating an operating parameter scheme corresponding to the at least one characteristic, the operating parameter scheme describing one or more operating parameters of a charged particle beam system, wherein the at least one characteristic includes a temporal pulse profile of an intensity of the light beam.

According to some embodiments, determining the at least one characteristic of the light beam further comprises: measuring an effective pulse duration of the light beam using Photon-Induced Near-Field Electron Microscopy (PINEM) spectra.

According to some embodiments, further comprising characterizing a temporal intensity distribution of the light beam based at least in part on the effective pulse duration.

One or more machine-readable storage media, storing executable instructions that, when executed, cause a charged particle beam system to perform operations comprising: directing a light beam pulse towards a sample within a charged particle column; directing a charged particle beam pulse towards the sample; detecting charged particles that, based at least in part on the light beam pulse and the charged particle beam pulse, interacted with the sample; determining a time delay between the charged particle beam pulse and the light beam pulse based at least in part on the charged particles; and determining at least one characteristic of the light beam pulse based at least in part on the time delay.

According to some embodiments, charged particle column is a transmission electron microscope (TEM).

According to some embodiments, the charged particle column includes a radio frequency (RF) cavity configured to generate a charged particle beam pulse.

According to some embodiments, a pulse frequency of the charged particle beam pulse is from about 25 MHz to about 100 MHz.

According to some embodiments, the operations further comprising: coupling the light beam into an optically conducting material.

According to some embodiments, the operations further comprising: adjusting a delay of light beam pulses or charged particle beam pulses towards the sample based at least in part on determining the at least one characteristic.

According to some embodiments, the operations further comprising: adjusting an intensity, frequency, or phase delay of the light beam pulses towards the sample based at least in part on determining the at least one characteristic.

A charged particle beam device comprising: one or more processors; and one or more machine-readable storage media, operably coupled with control circuitry, the media storing executable instructions that, when executed, cause operations comprising: directing a light beam pulse towards a sample within the charged particle beam device; directing a charged particle beam pulse towards the sample; detecting charged particles that, based at least in part on the light beam pulse and the charged particle beam pulse, interacted with the sample; determining a time delay between the charged particle beam pulse and the light beam pulse based at least in part on the charged particles; and determining at least one characteristic of the light beam pulse based at least in part on the time delay.

According to some embodiments, wherein the at least one characteristic of the light beam includes a characterization of a temporal asymmetry of the light beam.

According to some embodiments, the at least one characteristic of the light beam includes a pulse duration or a laser chirp.

According to some embodiments, the at least one characterization is used to characterize one or more optical modes in a microresonator.

### BRIEF DESCRIPTION THE DRAWINGS

The foregoing aspects and many of the attendant advantages of the present disclosure will become more readily appreciated as the same become better understood by reference to the following detailed description, when taken in conjunction with the accompanying drawings.
FIG. 1 is an example schematic diagram illustrating an example charged particle beam system, in accordance with some embodiments of the present disclosure.
FIG. 2 is an example schematic diagram illustrating a system for controlling a pulsed light source and a pulsed charged particle source, in accordance with some embodiments of the present disclosure.
FIG. 3 is an example block flow diagram illustrating a technique for generating a control signal in system of a pulsed light source and a pulsed charged particle source, in accordance with some embodiments of the present disclosure.
FIG. 4 is an example schematic diagram illustrating a technique for gating a pulsed charged particle source using a control signal from a light source, in accordance with embodiments of the present disclosure.
FIG. 5 is an example composite diagram showing periodic operation of a beam blanker, in accordance with embodiments of the present disclosure.
FIG. 6 is an example schematic diagram illustrating a technique for interrogating a pulsed light beam using a charged particle beam pulse, in accordance with embodiments of the present disclosure.
FIG. 7 is an example group of schematic diagrams illustrating example data for different pulsed light beam profiles, in accordance with embodiments of the present disclosure.
FIG. 8 is an example block flow diagram illustrating example processes for synchronizing and interrogating charged particle beam pulses and pulsed light beams, in accordance with embodiments of the present disclosure.
FIG. 9 is an example block flow diagram illustrating example processes for synchronizing and interrogating charged particle beam pulses and pulsed light beams, in accordance with embodiments of the present disclosure.
FIG. 10 is an example block flow diagram illustrating example processes for synchronizing and interrogating charged particle beam pulses and pulsed light beams, in accordance with embodiments of the present disclosure.
FIG. 11 is an example block flow diagram illustrating example processes for coarse and fine alignment of charged particle beams and pulsed light beams, in accordance with embodiments of the present disclosure.
FIG. 12 is an example block flow diagram illustrating example processes for synchronizing charged particle beams and amplified pulsed light beams, in accordance with embodiments of the present disclosure.
FIG. 13 is an example block flow diagram illustrating example processes for characterization of a light beam, in accordance with embodiments of the present disclosure.
FIG. 14 is an example block system diagram, in accordance with embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

### DETAILED DESCRIPTION

While illustrative embodiments have been illustrated and described, it will be appreciated that various changes can be made therein without departing from the spirit and scope of the disclosure. In the forthcoming paragraphs, embodiments of charged particle beam systems, components, and methods to synchronize pulsed beams of photons and charged particles in systems including such subsystems. Embodiments of the present disclosure focus on transmission electron microscopes and related instruments in the interest of simplicity of description. To that end, embodiments are not limited to such systems, but rather are contemplated for charged particle beam systems configured for use in "ultrafast" techniques to probe sample dynamics on relatively short timescales (e.g., on the picosecond, femtosecond, etc., timescale). Advantageously, synchronization of pulsed light beam and charged particles can improve the performance of ultrafast microscopy techniques, at least in part by decoupling the light source from the charged particle source (e.g., by using an RF resonant cavity to generate a charged particle beam pulse, rather than an optically pumped photoemitter). Further, independent control of the pulsed light beam and the charged particle beam pulse permits a time delay to serve as an independent variable in various techniques for optical interrogation of materials (e.g., microresonators) as well as temporal characterization of the pulsed light beam itself.

In charged particle microscopy, characterizing various parameters of a target (e.g., a circuit, wafer, biological sample, etc.) may include interrogating the target with a charged particle beam such as an electron beam. The electrons may interact with the target and may be detected by a detector for analysis and review. Typically, the process of characterizing the target requires multiple cycles of pulsing the electron beam at the target to acquire images. As such, imaging in charged particle microscopes is typically based at least in part on elastic interactions of electrons with the target. These elastic interactions may have no gain or loss of energy and may provide information about structure and bonding of the target. Inelastic interactions, in contrast, do have energy loss due to electron excitations in the target and are investigated in electron energy loss spectroscopy (EELS).

In UTEM, light beams (e.g., lasers) are used to study dynamic processes at short timescales, often in the femtosecond (10⁻¹⁵ seconds) range. One function of the laser is to provide ultrafast excitation to the sample. Synchronized electron pulses can be used for imaging during illumination, thereby enabling the capture of transient states and to how samples evolve in real time. Achieving synchronization between laser beams and electron beams in UTEM presents technical challenges, particularly in the context of time-resolved EELS. Precise temporal alignment between the light pulses used to excite the sample and the electron pulses used for spectroscopic interrogation is needed for resolving dynamic phenomena at femtosecond timescales. Deviations in synchronization can degrade the temporal resolution and compromise the ability to accurately capture transient states within the sample. Even minor fluctuations in the timing of either the light excitation or the electron pulse generation can result in temporal mismatches, thereby impacting the accuracy of EELS measurements and limiting a system's ability to resolve ultrafast dynamics.

Maintaining stability and coherence in both the laser pulses and the electron pulses further compounds the challenge. For time-resolved EELS spectroscopy, ultrafast lasers produce highly stable pulses on the order of femtoseconds, while electron pulses retain consistent energy distribution and shape. External factors, such as thermal drift, mechanical vibrations, and electronic noise, can introduce jitter or temporal drift in either the laser and/or electron pulse trains. Such instability can disrupt synchronization, reducing the reliability and precision of spectroscopic data.

Embodiments of the present disclosure tightly synchronize arrival time of charged particles and laser pulses at a sample with sub-picosecond jitter and may vary repetition rates to match detected responses of samples.

According to embodiments described herein, techniques are provided to synchronize various signals. For example, a radio frequency (RF) cavity may generate charged particle pulses and a laser oscillator may generate light beam pulses that may operate at roughly the same frequency. Synchronization of the charged particle pulses and the light beam pulses includes ensuring the charged particle pulses and the light beam pulses are operating at an exact same frequency and controlling a phase and/or time delay between the charged particle pulses and the light beam pulses. Synchronization is achieved by mixing signals from an RF driver coupled to the RF cavity and an optical driver coupled to a light source to produce a "coarse" or "rough" beat signal with respect to those two signals. The mixed signal may be used as feedback to the optical driver to synchronize the optical driver with the RF cavity. In addition, a "fine" or "precise" synchronization may be performed by switching a harmonic frequency of a signal from either the RF driver or the optical driver to minimize a time delay/phase delay between the two signals. In some embodiments, a beam blanker may receive a signal from the optical driver to control blanking and/or a signal may be sent to the optical driver based on a signal from the RF driver.

According to embodiments described herein, pulse picking techniques are provided to adjust a charged particle beam repetition rate. This adjustment may be done after synchronization has been performed as discussed above. In this manner, the light source may emit an amplified light beam pulse as a function of a beam blanker and/or a response time of the sample. A delay generator may receive the signal and trigger the beam blanker to rapidly unblank the charged particle beam such that the charged particle beam pulses only reach the sample when an amplified light beam pulse is emitted towards the sample. In this manner, the beam blanker may run at a fixed time delay relative to the RF cavity by receiving a signal from an optical driver, where the trigger signal has an inverse time delay so that the blanker is blanking the charged particle beam when the light source is not emitting so that the sample is interrogated by both the charged particle pulses and the light beam pulses at the same time.

According to embodiments described herein, a temporal characterization of the light beam may be performed. For example, charged particle pulses and the light beam pulses may interact at a sample which may lead to a splitting of an energy distribution of the charged particles into multiple sidebands. The more intense the light beam is, the broader the energy spectrum may become. A time delay between the laser and the charged particle beam may then be measured to generate a temporal profile of the light beam intensity. This output may reflect a true asymmetric temporal profile of the light beam whereas conventional devices can only provide symmetric profiles. These techniques not only apply to free space, but can beneficially be extended to light pulses inside photonic nanostructures. The information gained from the temporal characterization of the light beam may be beneficial to interpretation of probe experiments performed within charged particle microscopes.

Advantageously, embodiments of the present disclosure allow for a reduction of the repetition rate of electron pulses to an arbitrary frequency (e.g., as set by a laser system), while maintaining the pulse properties and timing accuracy of the RF cavity generated pulses. In contrast, the electron pulse frequency of conventional photoemission based ultrafast TEM is determined by the pulse frequency of the laser beam that is sent to the photocathode. Such techniques are limited by the challenges of an optical delay line as discussed in reference to the discussion above.

### I. Example Systems

### a. Charged Particle Beam System

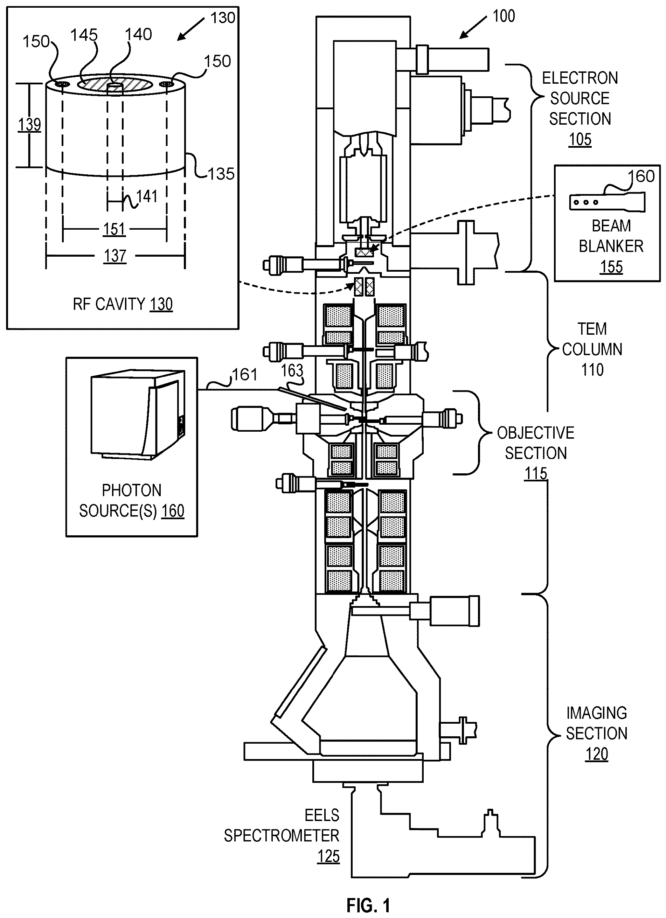

FIG. 1 is a schematic diagram illustrating an example charged particle beam system 100, in accordance with some embodiments of the present disclosure. In the following description, details of internal components and functions of the example system 100 are omitted for simplicity and to focus description on embodiments of the present disclosure. The example system 100 includes a charged particle source section, a TEM column (e.g., charged particle column) including a charged particle source section 105, a TEM column 110, an objective section 115, and an imaging section 120 (e.g., provided with an electron energy loss spectrometer 125). The example system 100 includes one or more components to enable "ultrafast" operation, such as a radio frequency (RF) cavity 130, a beam blanker 155, and one or more light sources 160. In the context of the present disclosure, "ultrafast" operation refers to a TEM system that is configured to generate detector data on the time scale of picoseconds, for example, through the use of pulsed beams for stroboscopic analysis. In this way, the relative position and sequence of the RF cavity 130 and the beam blanker 155 can vary in different embodiments of the present disclosure. For example, the RF cavity 130 can precede the beam blanker 155, and the components can be placed in different positions in the example system 100, in various approaches to producing a pulsed beam of electrons.

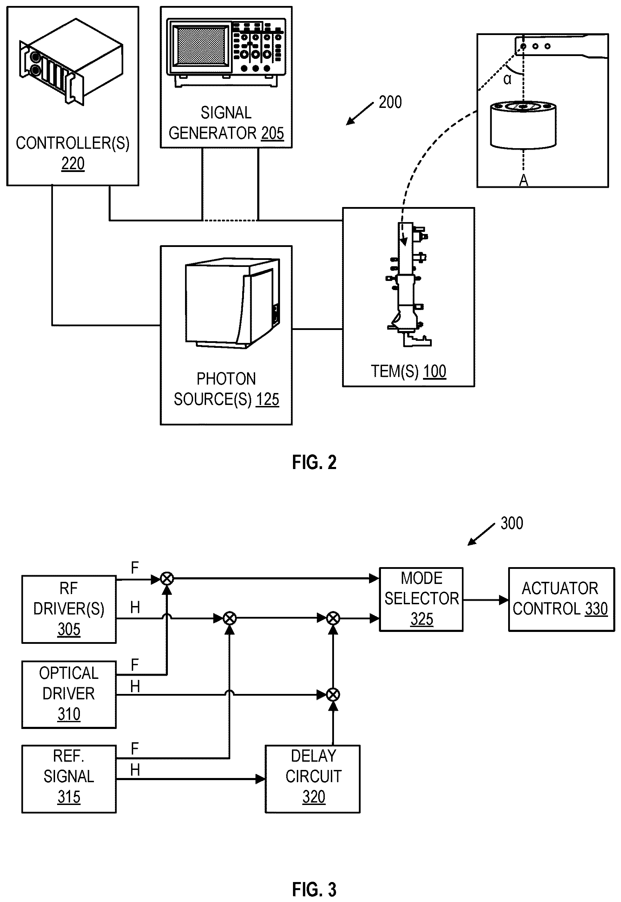

The charged particle source section 105 may include electronics configured to energize a source of charged particles, which can include a high-voltage field-emission source or other sources of emitted electrons, such that a beam of electrons is formed and conducted through a vacuum into the TEM column 110. The beam of electrons can be modulated using the beam blanker 155 to generate a train of pulses. The pulses can be generated by repeatedly deflecting the beam, in accordance with a trigger signal provided to the beam blanker, as described in more detail in reference to FIGS. 2-8. The beam blanker 155 can be an electrostatic element or an electromagnetic element. In some cases, a relaxation time of a magnetic field can limit the compatibility of an electromagnetic element with ultrafast operation. To that end, embodiments of the present disclosure may include an electrostatic beam blanker configured to periodically interrupt a continuous beam of electrons as an approach to generating a train of pulses characterized by a frequency from about one kilohertz (kHz) to about one hundred megahertz (MHz).

Downstream of the beam blanker 155, relative to the charged particle source section 105, the RF cavity 130 can be disposed such that the train of pulses pass through a body 135 of the RF cavity 130 via an aperture 140 defined in the body 135. The aperture 140 can be substantially centered about a beam axis of the example system 100, with the components of the RF cavity 130 being arrayed substantially symmetrically about the axis. The RF cavity 130 can include one or more antennas 150 disposed in the body 135. The antennas 150 can be electrically coupled with RF power circuits, and used to drive the antennas 150 at one or more RF frequencies. The antennas 150 can disposed in a dielectric or insulating insert 145, substantially concentric with the aperture 140. The behavior of the RF field in the aperture, such as the position of standing waves, can be based at least in part on the various distances 137, 139, 141, and 151 of the components of the RF cavity. For example, the distance 151 between the antennas 150 can influence the interaction of two RF fields in cases where each antenna may be driven at a respective RF frequency. The RF cavity 130 may be described in more detail in United States Patent US11328892B2, in European Patent EP3772745A3, and in Korean Patent KR102586724B1 and Korean Patent Application KR20230127968A, and in Japanese Patent JP7378366B2, entitled "Coating on dielectric insert of a resonant RF cavity," and in Chinese Patent CN112349571B, entitled "Radio frequency cavity and apparatus and system for use in charged particle microscopy," the disclosures of which are hereby incorporated by reference in their entireties.

The RF cavity 130 can be configured as a "dual mode" cavity, supporting two resonant modes at slightly offset field frequencies in the one to five gigahertz (GHz) range, including fractions, subranges, and interpolations thereof. The difference between the frequencies can result in a relatively lower frequency deflection of the charged particles over a downstream aperture (e.g., at about seventy-five MHz). The RF cavity 130 can include a pickup antenna, such that a second frequency at a harmonic of the relatively lower frequency can be derived from a signal from a pickup antenna inside the RF cavity. Advantageously, using the signal from the pickup antenna can reduce the effects of drift and instability in the RF cavity and associated drive circuitry, based at least in part on the signal for synchronization being derived from the actual field inside the RF cavity 130. In some cases, however, an electrostatic beam blanker with a bandwidth in the GHz range can be used with a single-mode RF cavity running from about one GHz to about five GHz (e.g., about 2.4 GHz). The beam blanker can directly modulate electron pulses of a 2.4 GHz sequence of pulses.

The TEM column 110 includes components for beam forming, including electromagnetic lenses and/or electrostatic lenses, and multiple apertures to control properties of the beam of electrons. TEM column 110 components include condenser lenses, objective lenses, projector lenses, aberration correctors, deflectors, stigmators, among others, as well as corresponding apertures. The objective section 115 hosts a sample through which a beam of electrons can be transmitted. The sample section can include one or more types of detectors, such as x-ray detectors, secondary electron detectors, etc.

The objective section 115 also includes an optical coupling 163 (e.g., by way of connector 161) with the light source(s) 160, by which photons can be introduced into the vacuum environment of the system 100 and can be directed toward the sample. In some cases, the light source(s) 160 include a fiber laser. The light source(s) 160 can be coupled with the objective section 115 via an optical fiber. In some embodiments, the light source(s) 160 are optically coupled with the objective section 115 via one or more optical elements (e.g., optical mirrors, lenses, irises, filters, etc.). Similarly, embodiments of the present disclosure include systems in which the optical coupling 163 is included as part of the charged particle source section 105 or in the TEM column 110 other than the objective section 115. In this way, the example system 100 can include one or more optical elements disposed within the system to direct and transform a light beam toward the sample.

The light source(s) 160 can include a laser that includes an oscillator and an output stage. The oscillator can be configured to generate optical pulses at a given frequency that is characteristic of the design of the oscillator (e.g., about seventy-five MHz). The output stage can include an optical amplifier or other gain medium, which can also include a switch to determine which pulses are actually outputted from the oscillator (e.g., one in every N pulses from the oscillator). In this way, the switch can act as a "pulse picker" and the switching signal can act as a trigger signal, which can be used to modulate the beam blanker 155, as described in more detail in reference to FIGS. 2-5.

A state-of-the-art TEM column 110 can have as many as four condenser lenses for flexible (e.g., step-wise or graduated) demagnification and concentration of the electron beam on the sample, and as many as five projector lenses for flexible magnification of the electron beam downstream of the sample to the detectors, and as many as two aberration correctors. Since a state-of-the-art aberration corrector can comprise additional lenses and several multipoles (e.g., four lenses and two-three or more multipoles), a modern TEM column 110 can include up to about twenty lenses. Coordinated operation of the ensemble of lenses and other optical elements results in a given demagnification at the sample and magnification at the detector.

The imaging section 120 includes one or more types of detector, sensor, screen, and/or optics configured to generate images, spectra, and other data for use in sample imaging and/or microanalysis. For example, the imaging section can include a scintillator screen, binoculars, transmission electron microscopy (TEM) detector(s) (e.g., pixelated electron detector, secondary electron detector, camera(s)), segmented STEM detector(s), and electron energy loss spectroscopy (EELS) spectrometer(s) 125, among others. The EELS spectrometer 125 functions as an energy filter at least in part by focusing the beam of electrons onto an electrostatic or magnetic dispersive element (also referred to as a "prism") that applies a force on an electron that is proportional to the velocity of the electron. In this way, electrons that have transferred energy to or from the sample (e.g., by inelastic collision(s)) can be redirected through the magnetic dispersive element and toward a detector. The detector can include a pixelated detector (e.g., a CCD device configured to detect electrons) that generates one or two dimensional EELS data, from which EELS spectra can be derived. In some embodiments, EELS spectrometer(s) 125 also include one or more optical elements, such as electromagnetic or electrostatic lenses and/or multipoles and/or accelerators, to condition and/or focus the scattered electrons onto the detector.

Embodiments of the present disclosure relate to ultrafast electron microscopy in a TEM system, an example of which is described in reference to FIG. 1. FIGS. 2-10 concern techniques for improving the performance of a TEM system in ultrafast mode, including techniques for synchronizing an RF cavity (e.g., RF cavity 130 of FIG. 1) electron beam pulser to a laser system (e.g., light source(s) 160 of FIG. 1). A goal of the technique is to reliably phase-lock the laser signal and electron beam signal. Another goal is to achieve a controllable time delay between pump light beam pulses directed to a specimen in the TEM and electron pulses for probing the same specimen.

In the current art, which relies on a photoelectron emitter for laser-based ultrafast TEM, synchronization between a pump and a probe of the setup is achieved by an optical circuit that divides a light beam pulse into a pump pulse and a probe pulse, one of which is used to directly irradiate a sample, while the other is used to stimulate photoelectric emission, producing a synchronized pulse of electrons. Drawbacks of the laser-based techniques include relaxation time properties of the photoemitter, saturation effects, and residual emission that are typically addressed by beam chopping methods. Using a chopper/beam blanker in the TEM, in turn, implicates active synchronization between two sources (the pump and the probe) that inherently each have their own clocks. Synchronization at the picosecond timescale presents significant challenges.

Embodiments of the present disclosure address challenges with synchronization at least in part by mixing signals coming from both sources, as illustrated in FIG. 3, thereby deriving a signal that scales with a time offset between the two signals, and in a control loop, adjusts the length of a laser oscillator (e.g., through one or more piezo positioners) to eliminate the time offset.

### b. Signal Control Components

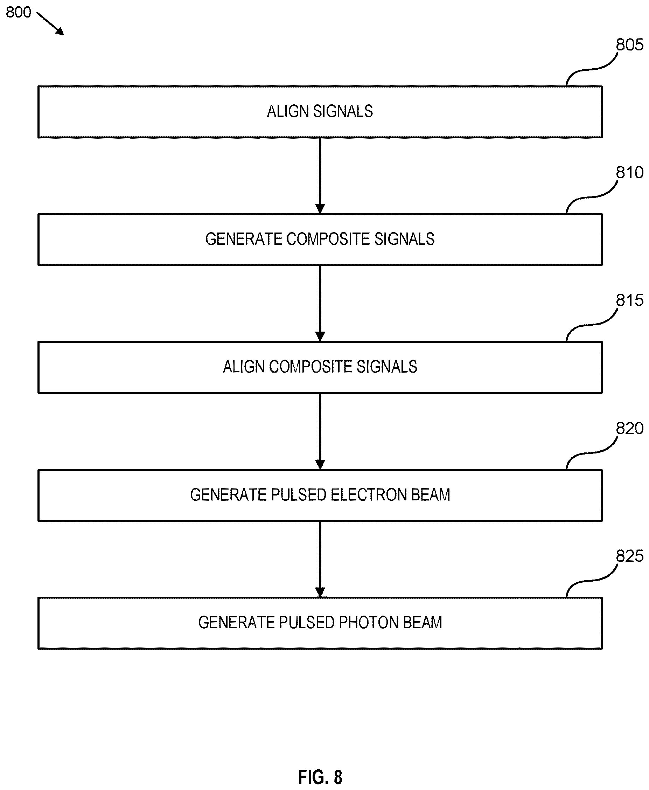

FIG. 2 is an example schematic diagram illustrating a system 200 for controlling a pulsed light source and a pulsed charged particle source, in accordance with some embodiments of the present disclosure. A detailed example of the techniques of the present example, as described in reference to FIG. 2 and FIG. 8, includes using an RF signal from the RF cavity module (e.g., RF driver(s) 305) to derive output signals for at least two frequencies, where the first frequency ("F" in FIG. 3) corresponds to a frequency of the light source 160 and the second frequency is a harmonic ("H" in FIG. 3) of the first frequency. The example technique includes electronically mixing both signals with corresponding signals from a light beam system (e.g., optical driver 310) which may be a laser. The example technique includes using the first (lower frequency) signal to define a coarse phase lock between the electron signal and the laser signal.

FIG. 3 is an example block system 300 illustrating a technique for generating a control signal in system of a pulsed light source and a pulsed charged particle source, in accordance with some embodiments of the present disclosure. As shown in FIG. 3, mixing the two signals at the first frequency can include a vector multiplication of the two signals to define an error signal, which can form the basis of a feedback control scheme including one or more parameters of the laser or the reference signal 315 as control variables. Each vector multiplication symbol ⊗ shows the forming of a composite signal. In a non-limiting example, the error signal is one of four calculated shown in FIG. 3.

Optimization of the error signal can be achieved through one or more control methods, such as, for example, a PID-style feedback control model using the error signal as the controlled variable and the characteristic length of the laser oscillator as the modulated variable, with a set point of zero for the error signal, within an allowable tolerance, for example. The optimization of the first error signal can correspond to a "coarse" synchronization of the laser and RF signals, after which the control techniques transition to the second frequency (H) signals for phase locking. In some embodiments, an electronic time delay is applied to one of the two higher-frequency signals (e.g., the RF harmonic signal or the laser/optical harmonic signal). An error signal can be generated using the two second frequency signals, of which one includes the time delay. The error signal can be used to generate a feedback signal to one or more piezos in the laser oscillator, so the oscillator output becomes locked to the reference signal 315. As shown in FIG. 3, a reference signal can be mixed with the second frequency (H) signals. Advantageously, one of the reference signals carries the electronic time delay (e.g., delay circuit 320). The reference signal can have a frequency from about one MHz to about one hundred MHz, including subranges, fractions, and interpolations thereof. In some examples, a default method to vary time delay is to apply an electronic time delay to one of the frequency signals (e.g., the higher of the frequency signals). In addition, or alternatively, for relatively small time delay variations may involve adding a DC offset to the error signal. Adding the DC offset may be used to scan a time delay over a small range (±1 to 2 picoseconds (ps)), with high accuracy.

In some embodiments, the first frequency differs from the frequency of the field inside the RF cavity and/or or the frequency of the action of the cavity on the electrons. The first frequency can also be a submultiple of either. For example, the first frequency can be equal to the laser oscillator frequency but can also be a multiple of the laser oscillator frequency (e.g., in view of the discussion above, where a fast beam blanker is used to achieve an equal value for electron and optical pulse frequencies). In this case, the first frequency (F) can be a fraction of both the frequency of the field in the cavity and the frequency of the cavity-generated electron pulses (e.g., about seventy-five MHz).

In practice the synchronization can be achieved, using actuator control 330, at least in part by a) modifying a signal generator 205 (e.g., RF driver) to provide an additional synchronization output at about six hundred MHz, derived from the 2.4 GHz master optical pulse signal, in addition to a seventy-five MHz synchronization signal; b) using a tunable pulsed laser module (e.g., light source 160), including synchronization controller 220 electronics; and c) connecting the RF sync outputs to the respective seventy-five MHz and six hundred MHz sync inputs of the controller 220 of the light source 160.

Advantageously, the techniques of the present disclosure obviate the need for an optical delay line in the laser path and provide nominally consistent light beam pulse properties on the sample. Further, implementing the systems/diagram 200, 300 as illustrated in FIG. 2 and FIG. 3 has little to no impact on the performance of the RF subsystem from the phase locking action. Additionally, the time delay can be electronically selected and/or defined, removing physical bounds on the length of the time delay that are imposed by a physical time delay optic (e.g., permitting potentially unlimited time delay not bound by a length of a delay line). Finally, the techniques of the present disclosure permit higher frequency locking for better accuracy, while also preventing phase ambiguity by starting from the base frequency of both systems, which can result in false convergence for a system with multiple stationary points.

While the general concept of RF to laser synchronization have been described, a significant limitation of existing methods is that time delay is introduced using an optical delay line. As such, a time delay is typically implemented in either of the branches (optical delay line or RF phase shifter). An optical delay line has the drawback that varying the delay inevitably has an impact on the positioning and/or focusing of the laser beam on the sample, implicating alignment and optical stability challenges. Likewise, a phase shifter in the RF signal path can negatively impact the amplitude and/or phase stability of the RF signal, implicating recalibration of internal components of the TEM system. Another drawback of some systems is the necessity for a deep integration between the laser system and the RF driver, limiting the flexibility of component selection which implicates, in turn, a dedicated TEM system, rather than a flexible ultrafast mode.

To that end, embodiments of the present disclosure include a "multi-mode" TEM system that includes an ultrafast mode using an RF cavity for beam chopping and a dual mode cavity (e.g., producing a beat frequency in the range of typical laser oscillators), and/or using a pickup antenna inside the RF cavity for producing the synchronization signal. In some embodiments, a pickup antenna inside the RF cavity is used to generate a synchronization signal directly from the actual standing wave of one of the modes in the cavity, thereby attenuating some sources of timing uncertainty in the RF module. This can be augmented using a higher harmonic second frequency (e.g., higher than six hundred MHz) for the fine phase locking (e.g., mode selector 325 with respect to FIG. 3). For example, using a 1.2 GHz harmonic frequency can reduce variance in the error signal, additionally and/or alternatively to reducing instabilities in both types of signals, (e.g. using a more stable RF source), laser beam pointing correction (before it falls on a photodiode). The error signal can also be used to estimate instability between the RF and laser timings.

### c. Charged Particle Beam Control

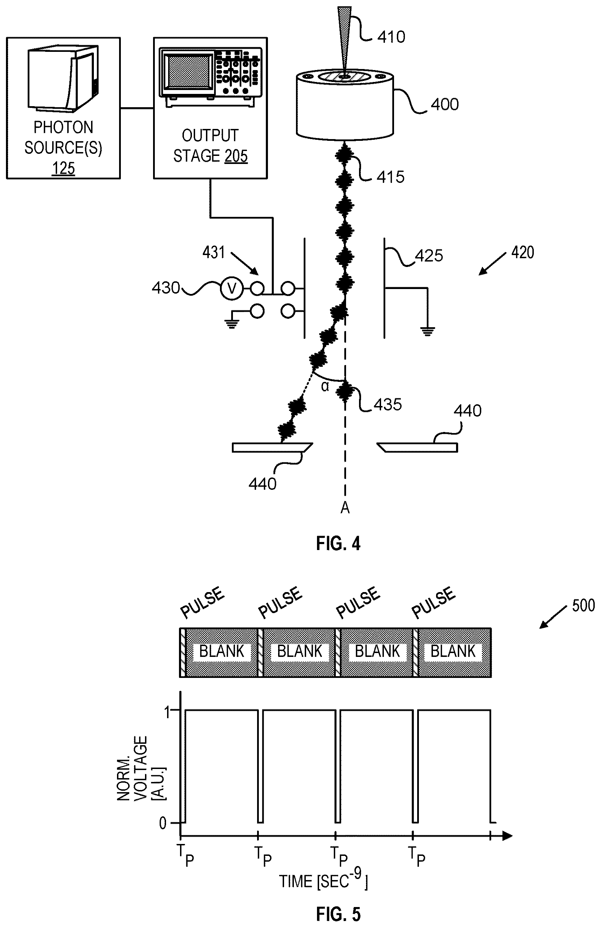

FIGS. 4-5 generally relate to ultrafast TEM in general, and to using an RF cavity-based electron beam pulser in combination with an amplified laser system, as described in more detail in reference to FIGS 1-3. In some cases, an amplified laser system will generate pulsed light beams at a given pulse rate, of which a subset of the pulses will be amplified. To that end, embodiments of the present disclosure enable pulsed particle beam systems to align the repetition rate of a charged particle beam pulse with the amplified output of a pulsed laser system, at arbitrary repetition rates.

FIG. 4 is an example schematic diagram 400 illustrating a technique for gating a pulsed charged particle source using a control signal from a light source, in accordance with embodiments of the present disclosure. A resonant RF cavity 401 can operate at substantially fixed frequencies within a tuning range and may receive a charged particle beam 410. RF cavities can be synchronized with a light source 160, as described in more detail in reference to FIGS. 2-3, and can be adjusted such that the electron pulse frequency and light beam pulse frequency are synchronized to an arbitrary pulse frequency, across a relatively wide range of frequencies, through the application of an adjustable amplifier (e.g., signal generator 205) for the pulsed laser system and a beam blanker for the charged particle beam pulse 415, as described in more detail in reference to FIG. 1.

To that end, a beam blanker 420 (e.g., beam blanker 155 of FIG. 1) can be used as a pulse picker, to sample a subset of charged particle beam pulses 435 generated by a resonant RF cavity 401. The beam blanker 420 can include electrodes 425, a voltage supply 430 coupled with the electrodes 425 via a high frequency switch 431 that can be coupled with the amplifier of the laser system and/or via a common signal generator configured to generate a trigger signal to the laser amplifier and the switch 431. In this way, the beam blanker 420 can be synchronized with a laser amplifier or shutter or have both the pulse picker and the laser amplifier or shutter synchronized to a common trigger signal.

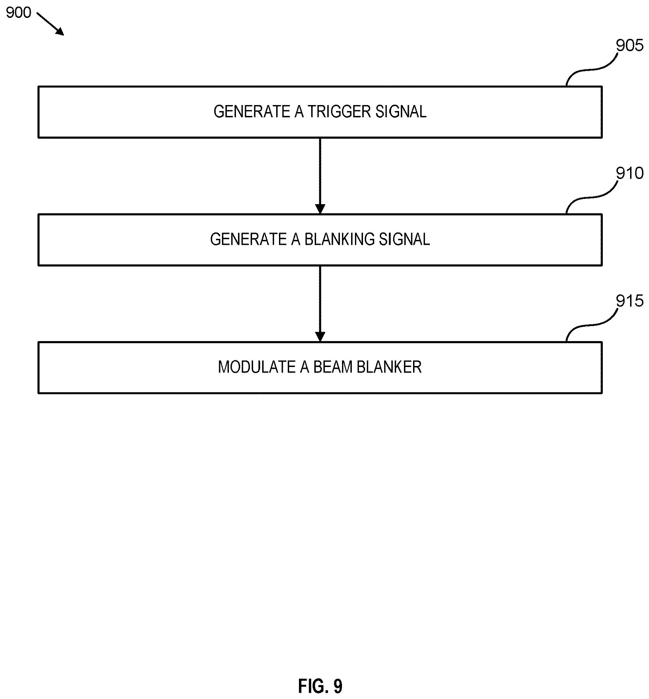

An example process (e.g., FIG. 9) includes generating a charged particle beam pulse from a continuous electron beam using the RF cavity 401 or another high frequency beam modulator. The example process also includes using a high frequency beam blanker (e.g., an electrostatic beam blanker) or a second beam modulator as a "pulse picker." In this context, a "pulse picker" refers to the action of the optical element to periodically block the passage of electron pulses by deflecting pulses into a beam block, aperture 440, etc., in accordance with a trigger signal.

The example process also includes synchronizing the RF cavity synchronized to the laser oscillator as described in above and in reference to FIGS. 2-3. The RF cavity 401 can be configured to produce pulses at a repetition rate equal to or at a multiple of the laser oscillator frequency. The pulses can be subsampled by controlling the pulse picker (e.g., beam blanker 420) such that it opens at the same repetition rate as the amplified output of the laser, at that time letting through one or more pulses of electrons.

In typical femtosecond pulsed laser designs, the amplified laser output frequency is an exact sub-multiple of the oscillator frequency, such that exactly one in N pulses is amplified, where N is an integer larger than one. In this way, the laser amplifier and the pulse picker can be synchronized to a common trigger signal, but the pulse picker can also be synchronized to a signal from the laser. When the pulse picker is synchronized to the laser, an 'inverse' time delay variation can be applied to the pulse picker, to account for a time delay of the laser with respect to the RF signal. Advantageously, the 'inverse' time delay reduces or eliminates instability in the pulse picking.

FIG. 5 is an example composite diagram 500 showing periodic operation of a beam blanker, in accordance with embodiments of the present disclosure. A time-delayed output from a delay generator can be configured to trigger an Electrostatic Beam Blanker (ESBB) driver. The trigger signal can be synchronized with the amplifier and/or shutter of the laser, which allows using the amplified output of the laser at arbitrary submultiple frequencies. In some cases, as when accommodating hardware response time limitations, a trigger signal can unblank the beam blanker in time for the next laser pulse, which comes at a known period after the current one. A time delay from about ten nanoseconds (ns) to about five hundred ns can improve temporal overlap between the 'picked' electron pulse and the light beam pulse on the specimen, although this time delay depends on a variety of experimental parameters. In some embodiments, the time delay can be about equal to a time between subsequent light beam pulses (e.g., about 9.07 microseconds for a pulse frequency of about 110.3 kHz), plus a fixed offset from about negative ten ns to about negative one thousand ns. This represents the "inverse time delay" where a positive delay is applied to beam blanker, but resulting in a negative time delay relative to the next laser pulse (e.g., next photon beam pulse). For long scan time delays, as the RF pulse is time delayed relative to the light beam pulse (e.g., a negative relative delay of the laser pulse), the ESBB time delay can be adjusted accordingly. In this way, the time delay between RF and laser outputs can be delayed by a given value in time (e.g., positive), and an opposing (e.g., negative) time delay between the laser and the fast beam blanker can be applied, with the end result being to maintain the RF beam pulser and the beam blanker synchronization, while providing that the electron pulses and light beam pulses are time-shifted relative to each other. Within a relatively narrow range of the time delay between pulsed light beams and electron pulses, the time delay between laser and charged particle beam systems can be static. However, for large time delays, for example, on the order of the oscillator period, or larger, the pulse picker time delay can be 'scanned' relative to the laser signal to ensure the RF beam pulser and the beam blanker remain synchronized.

### d. Charged Particle Beam and Light Beam Techniques

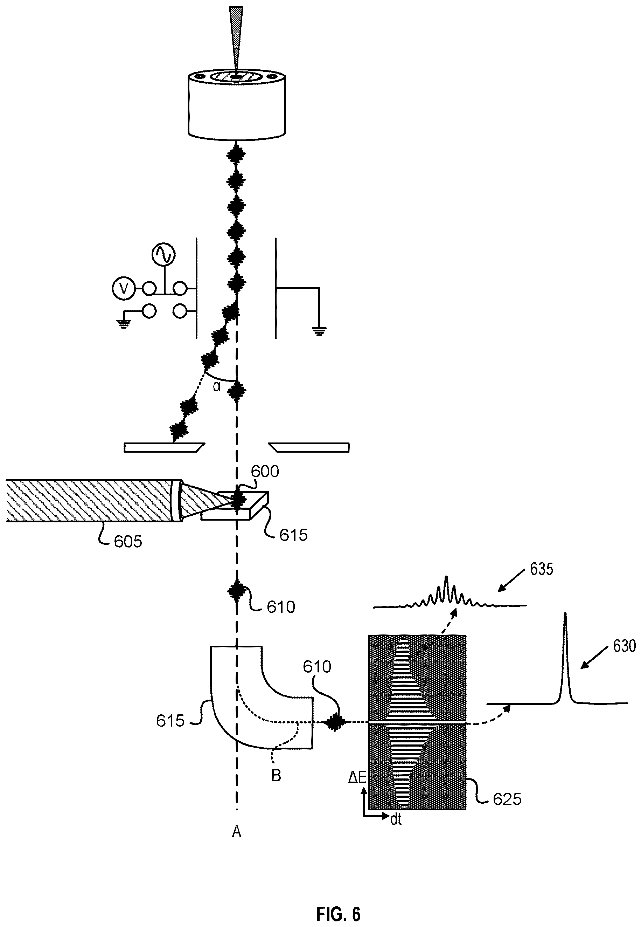

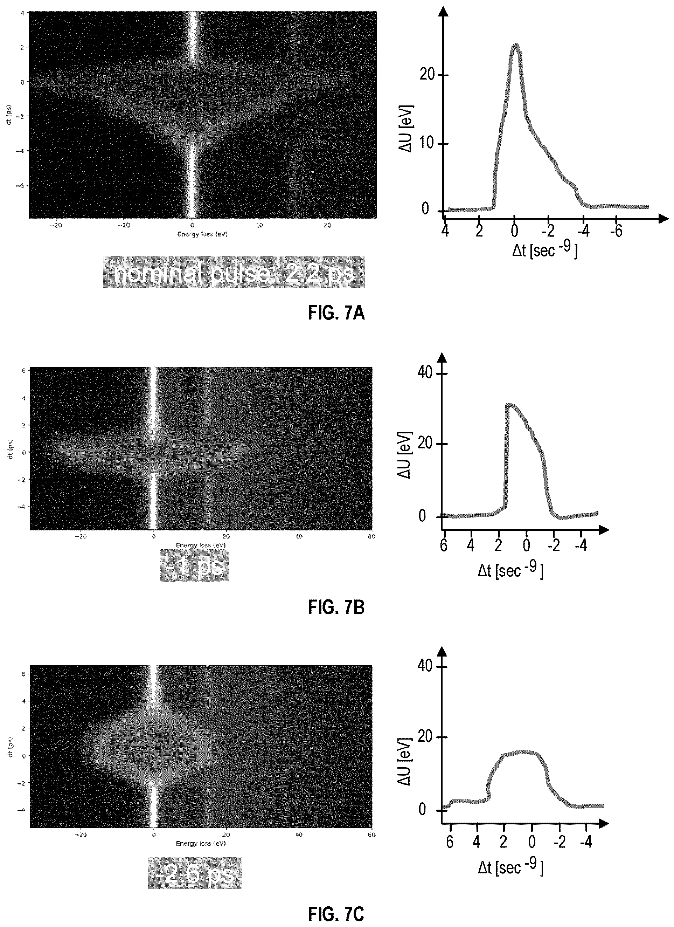

FIG. 6 is an example schematic diagram 600 illustrating a technique for interrogating a pulsed light beam using a charged particle beam pulse and FIG. 7 is an example group of schematic diagrams 700 illustrating example data for different pulsed light beam profiles, in accordance with embodiments of the present disclosure. FIGS. 6-7 relate to ultrafast TEM in general, and to using an RF cavity-based electron beam pulser in combination with an light beam source (which may be an amplified beam source), as described in more detail in reference to FIGS. 1-5. In some cases, an amplified laser system will generate pulsed light beams with temporal pulse profiles 625 (and illustrated examples in FIG. 7) that can be controlled based at least in part on the operating parameters of the amplified light source. To that end, embodiments of the present disclosure enable a charged particle beam pulse to interrogate the temporal profile of the pulses being generated by the laser system.

To that end, a process for interrogating a light beam pulse (e.g., FIG. 13) includes overlapping a charged particle beam pulse 601 with light beam pulses 605 on a sample 615, for example, in a TEM configured for ultrafast operation. Inelastic scattering of an electron beam through the light beam pulses 605 generates a subset of charged particles 610 with modified energy levels which are received in an EELS spectrometer 645 (which is an example of EELS spectrometer 125 with respect to FIG. 1) and directed (along B) towards a detector (not depicted). The detector may detect the permits the pulse profiles 630, 635 to be derived over multiple pulse measurements, based at least in part on scanning a relative time delay to sample the pulse profile over a set of timesteps, using photon-induced near-field electron microscopy principles.

A Photon-Induced Near-Field Electron Microscopy (PINEM) method permits interrogation of time-varying nanoscale electromagnetic fields in an electron microscope, which is enabled on picosecond timescales using ultrafast TEM. For visible light, inelastic coupling between electrons and light is physically forbidden in free space, but is permitted by confining near-field radiation on a surface or nanostructure. In PINEM, confinement on the sample 615 generates evanescently confined near-fields with a broad momentum distribution, reaching high intensities in a nanoconfined space and thus also boosting the cross section of electron-light coupling. In this way, the processes of the current disclosure include recording a PINEM spectrum and scanning the time delay between electron and light beam pulses to record one or more additional spectra. Together, the PINEM spectra are used to measure the effective pulse duration of the laser pulse, and can be used to characterize the temporal intensity distribution of a pulsed laser. The method allows full characterization of the temporal profile of the laser intensity.

Conventionally, autocorrelators are used for characterizing ultrashort (e.g., picosecond to femtosecond scale) light beam pulses. A drawback of autocorrelators is that there is no 'sign' in the time scale; the output is always symmetric with respect to the peak intensity ( e.g., time of maximum overlap). This limitation, which impairs the flexibility and robustness of the ultrafast systems, can be addressed by cross correlating the light beam pulse signal with a different signal, such as the electron pulse signal.

For example, the amplified output of a pulsed laser can be used for PINEM experiments. Where the laser system has a pulse compressor built into the amplified output path of the laser, variation of the final pulse duration from about one hundred femtoseconds (fs) to about one hundred picoseconds (ps) can be applied. Using time delay scans of the light beam pulses at various compressor settings, PINEM spectra of varying width can be collected as a function of relative time, representative of the intensity variation during the laser pulse. In contrast, autocorrelators that are commercially available and are capable of characterization of the temporal profile of light beam pulses always generate symmetric output, which lacks any information on the temporal asymmetry of the laser pulse. Advantageously, information about the asymmetry of the light beam pulse can improve accuracy and precision of microanalysis including ultrafast light beam pulse exposure. To that end, techniques of the present disclosure include processes for derivation of temporal intensity profiles of one or more light beam pulses, as well as pulse duration and laser chirp. Laser chirp, as an example, can be measured by varying peak separations in the PINEM spectra, as a function of time delay. Techniques of the present disclosure can be extended to applications in photonics and functional materials. In an illustrative example, an optically active material can be interrogated using the pulsed beam techniques described, as an approach to temporally characterize one or more optical modes in a microresonator. Optical modes include solitons or pulses that give rise to frequency combs. Measuring temporal characteristics of optically active materials relies on synchronization of electron pulses to the mode of the microresonator being interrogated, and can benefit from a relatively shortened pulse duration to improve temporal resolution of the mode shape.

### II. Example Processes

### a. Signal Synchronization Processes

Synchronizing light beam pulses with charged particle beam pulses in transmission electron microscopy (TEM) is technically challenging. These challenges arise due to the inherent differences in how light beam pulses and charged particle beam pulses are generated, directed, and/or modulated. Light beam pulses (e.g., generated by laser oscillators) can operate at high frequencies with femtosecond-scale precision, while charged particle beams, such as charged particle beam pulses, are subject to limitations imposed by the charged particle beam source, beam blanker, and switching electronics. Achieving synchronization needs precise timing control systems that align the light beam pulses and charged particle beam pulses from both sources in terms of phase, duration, frequency, and arrival times at the sample. Misalignment can occur due to jitter in the trigger signals, variations in beam path lengths, and/or discrepancies in pulse durations.

When light beam pulses and charged particle beam pulses are not synchronized, the sample can be affected in several ways. For pump-probe experiments, synchronization ensures that the light beam pulses excite the sample at substantially at the same time relative to the arrival of the charged particle beam pulses enabling images and video in real-time to be captured. Without synchronization, the charged particle beam pulses may interrogate the sample before or after the light beam pulse induced excitation has occurred, resulting in incomplete and/or misleading data about the samples intermediate (e.g., transient) states. This may lead to erroneous interpretations (by users or machine) of the samples structural or thermal properties, for example. In addition, or alternatively,, unsynchronized pulses can cause repetitive or uneven energy delivery to the sample, potentially damaging sensitive materials or inducing thermal effects that obscure results.

The lack of synchronization also leads to significant time inefficiencies in experimental workflows. When the sample undergoes excitation from unsynchronized pulses, it may not return to its equilibrium state immediately, necessitating a waiting period for relaxation before the next pulse sequence can be applied. This waiting time compounds over the course of an experiment, slowing data collection and reducing throughput which increases production time and costs. Additionally, repeating measurements multiple times to account for inaccuracies caused by unsynchronized pulses may add additional time. Synchronizing the arrival of the light beam pulses and the charged particle beam pulses may decrease time spent performing analysis of the sample, improve the quality of the analysis, and decrease processing power needed to perform the experiment.

FIG. 8 is an example block flow diagram illustrating example processes 800 for synchronizing and interrogating charged particle beam pulses and pulsed light beams, in accordance with embodiments of the present disclosure. In some examples, the process 800 may be implemented by some or all components of systems, devices, and/or include processes, methods, or techniques as those described in relation to FIGS. 1-7 and 9-14. In some embodiments, the process 800 may include more or fewer steps than the number depicted in FIG. 8. It should be appreciated that the steps may be performed in any suitable order. A process 800 begins at step 805 where aligning and/or synchronizing a pulsed electron beam with a pulsed light beam (e.g., pulsed photon beam) occurs, as illustrated with respect to FIGS. 1-6. The process 800 can include synchronizing an RF signal and an optical pulse signal. The process 800 can include generating composite signals 810 using the RF signal, the optical pulse signal, and a reference signal. The process 800 can also include aligning and/or synchronizing the composite signals 815.

In some embodiments, the RF signal describes a frequency generated by an action of an RF cavity on a beam of electrons. The action of the RF cavity on the beam of electrons can include sweeping the beam of electrons 820 (e.g., charged particle beam pulse) across an aperture placed in a path of the beam of electrons. A pulse frequency of the optical pulse signal (e.g., pulsed light beam) 825 can be from about twenty five MHz to about one hundred and twenty five MHz.

In some embodiments, the RF signal and the optical pulse signal are frequency-matched. Frequency matched signals can correspond to a condition wherein a first harmonic frequency of the RF signal is substantially equal to a first harmonic frequency of the optical pulse signal.

In some embodiments, synchronizing the RF signal and the optical pulse signal include generating an error signal using a first harmonic frequency component of the RF signal and a first harmonic frequency component of the optical pulse signal. Synchronizing the RF signal and the optical pulse signal can also include modifying one or more parameters of a pulsed light source, as part of an optimization of the error signal. Generating the error signal can include generating a vector-product of the RF signal and the optical pulse signal and filtering the vector-product to remove high frequency components of the vector-product. The high frequency components can include harmonic frequencies higher than the fundamental frequency component.

In some embodiments, the pulsed light source is a pulsed laser source. The one or more parameters can include a characteristic length of a laser oscillator of the pulsed laser source. The characteristic length can describe a path length of the oscillator between two reflectors, with one or more of the reflectors being movable relative to a gain medium.

In some embodiments, generating the composite signals includes generating an RF composite signal, using a vector-product of a harmonic frequency component of the RF signal and the reference signal and generating an optical composite signal, using a vector-product of a harmonic frequency component of the optical pulse signal and the reference signal. The harmonic frequency can refer to a harmonic order higher than the first, or fundamental, frequency. Generating the optical composite signal can include adding a time delay to the vector-product of the harmonic frequency component of the optical pulse signal and the reference signal. The time delay can be a variable time delay.

In some embodiments, the reference signal has a frequency from about five MHz to about fifty MHz. Optionally, the frequency can be about twenty MHz.

In some embodiments, synchronizing the composite signals includes generating an error signal using the composite signals. Synchronizing the composite signals can also include modifying one or more parameters of a pulsed light source, as part of an optimization of the error signal. Generating the error signal can include generating a vector-product of the RF composite signal and the optical composite signal and filtering the vector-product to remove frequency components of the vector-product outside a passband including the harmonic frequency component of the optical pulse signal and the harmonic frequency component of the RF composite signal.

FIG. 9 is an example block flow diagram illustrating example processes 900 for synchronizing charged particle beam pulses and pulsed light beams, in accordance with embodiments of the present disclosure. In some examples, the process 900 may be implemented by some or all components of systems, devices, and/or include processes, methods, or techniques as those described in relation to FIGS. 1-8 and 10-14. In some embodiments, the process 900 may include more or fewer steps than the number depicted in FIG. 9. It should be appreciated that the steps may be performed in any suitable order. Some, particular, or all steps as applicable may be performed in a time domain and/or a frequency domain depending on a signal processing implementation.

At 902, an optical pulse signal may be generated from a light source that emits a light beam pulse towards a sample. The charged particle column may include (or be attached to) an optical driver (e.g., optical driver 310 with respect to FIG. 3) to generate, or determine, an optical pulse signal at a first frequency (e.g., "F" in FIG. 3). The first frequency "F" can be a fraction of both the frequency of the field in the RF cavity and the frequency of the cavity-generated charged particle beam pulses (e.g., charged particle beam pulse 415).

At 904, a radio frequency (RF) signal (e.g., from RF driver 305 with respect to FIG. 3) may be generated associated with a RF cavity that pulses a charged particle beam towards the sample. For example, the association may be that the RF signal is directly retrieved from the RF driver which sends the RF signal to the RF cavity or the associated may be that the RF signal is measured from the RF cavity (or suitable equivalents) and is then used to generate the composite signal (as discussed in FIG. 3). To that end, the RF signal may, in some examples, be used to control the RF cavity as well as provide a RF signal for the composite vector multiplication or may not be used to control the RF cavity. The RF signal may be received by an RF cavity (e.g., RF cavity 130 with respect to FIG. 1). The RF cavity may be a dual mode cavity. In addition, or alternatively, the RF cavity may include a pickup antenna. In some examples, the RF signals used for synchronization may be directly derived from the RF signal (e.g., from RF driver 305). In addition, or alternatively, the pickup antenna may be used to determine the RF signal. As such, RF signals used for synchronization, which are vector multiplied with the optical pulse signal to generate the composite signals, may be the same as the RF signal for controlling the RF cavity or may be a result of a RF signal detected by the pickup antenna.

In some embodiments, a coarse alignment of the RF signal and the optical pulse signal may be performed. For example, at 906, a composite signal may be generated using at least the RF signal and the optical pulse signal. The RF signal and the optical pulse signal may be mixed at the first frequency to produce a composite signal. Producing the composite signal may involve generating an error signal using a first harmonic frequency component of the RF signal and a first harmonic frequency component of the optical pulse signal and modifying one or more parameters of a light source, as part of an optimization of the error signal. In some examples, generating the error signal includes generating a vector-product of the RF signal and the optical pulse signal and filtering the vector-product to remove high frequency components of the vector-product. In addition, or alternatively, the high frequency components may include harmonic frequencies higher than the fundamental frequency component.

At 908, the light source may be controlled (e.g., control one or more parameters of the light source such as oscillator length) or RF signals to control the RF cavity may be controlled based at least in part on the composite signal such that the light beam pulses and charged particle beam pulses are synchronized at the sample (e.g., as shown in FIG. 6).

In some examples, the light source may be a pulsed laser source and modifying the one or more parameters may include modifying a characteristic length of a laser oscillator of the pulsed laser source. In addition, or alternatively, the characteristic length describing a path length of the oscillator between two reflectors, with one or more of the reflectors being movable relative to a gain medium (e.g., titanium-doped sapphire).

According to some embodiments, generating an RF composite signal, using a vector-product of a harmonic frequency component of the RF signal and a reference signal. In this example, generating an optical composite signal may use a vector-product of a harmonic frequency component of the laser oscillator and the reference signal. In addition, or alternatively, the harmonic frequency component may be a harmonic order higher than a fundamental frequency.

In some examples, generating an RF composite signal may include using a vector-product of a harmonic frequency component of the RF signal and a reference signal (e.g., reference signal 315 with respect to FIG. 3) between five MHz and fifty MHz, and preferably about twenty MHz. Generating an optical composite signal may include using a vector-product of a harmonic frequency component of the oscillator and the reference signal such that the harmonic frequency component may be a harmonic order higher than a fundamental frequency. In addition, or alternatively, generating the composite signal may include adding a time delay to the vector-product of the harmonic frequency component of the optical pulse signal and the reference signal. The time delay may be a variable time delay.

In some embodiments, a fine alignment of the RF signal and the oscillator may be performed. For example, and returning to the discussion of 908, a harmonic signal may be generated based at least in part on the first frequency and an error signal may be generated based at least in part on the composite signal. One or more parameters (e.g., intensity, frequency, phase, etc.) of a light source may be modified, as part of an optimization of the error signal. In some examples, the error signal may include generating a vector-product of the composite signal, and filtering the vector-product to remove frequency components of the vector-product outside a passband including a harmonic frequency component of the optical pulse signal and a harmonic frequency component of the RF signal. According to some embodiments, the first frequency may a fundamental frequency of the RF driver and/or the optical driver, and performing fine alignment of the RF signal and the optical pulse signal may include switching, at a mode selector (e.g., mode selector 325 with respect to FIG. 3), from phase locking at the first frequency to phase locking at a harmonic frequency of the RF driver and/or the optical driver.

In some embodiments, the composite signal may be mixed with the harmonic signal to produce a beat frequency signal. The beat frequency signal may define feedback for the light source (e.g., laser oscillator). A path length may be adjusted to keep a tight (e.g., less than one picosecond (ps) jitter) phase lock with the signal driving the RF cavity. In some examples, delay between the light beam pulses may be adjusted electronically without moving parts.

According to some embodiments, the optical driver may be phase locked to the RF driver based at least in part on the beat frequency signal. The beat frequency signal may help control a time delay and/or phase between the optical driver and the RF driver. In examples where the optical driver and the RF driver are already matched, the result may include a DC error signal that represents the time delay between the pulses. The time delay may be steered towards zero to keep the light source overlapping with the charged particle beam source.

### b. Beam Blanking Processes

Synchronizing a light source and a beam blanker uses a signal associated with the light source as a trigger signal that the beam blanker can use to blank a charged particle beam. The beam blanker may use the trigger signal to deflect or blocks the charged particle beam at specific intervals to generate pulses. Variations in the trigger signal timing from the light source can introduce delays or inaccuracies in the beam blanker response. In addition, or alternatively, mechanical and electronic components of the beam blanker may introduce latency or jitter, making precise alignment with the light source signal more difficult.

Triggering a beam blanker as a function of a light source signal may allow for controlled interaction between the charged particle beam pulses and the sample during specific time periods. Synchronizing the beam blanker with the light source signal synchronizes the charged particle beam pulses to transmit during desired intervals, reducing unnecessary exposure to the sample and improving the quality of collected data (e.g., images, video, etc.). By synchronizing the beam blanker to the light source, an analysis of the samples transient states may enable observation of ultrafast processes and dynamic changes in the structure or properties of the sample.

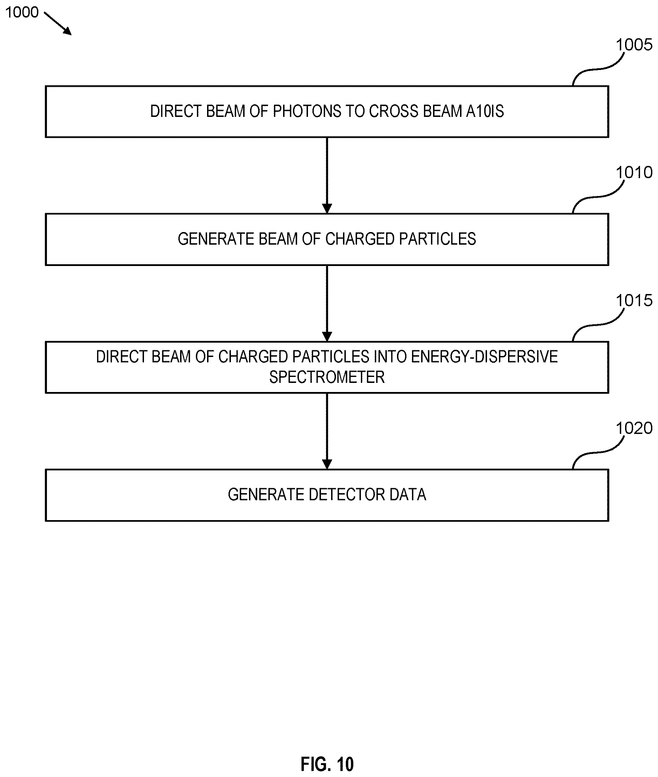

FIG. 10 is a block flow diagram illustrating example processes for triggering a beam blanker. By aligning the timing, frequency, and duration of a trigger signal with a light beam pulse, the charged particle beam can be precisely blocked or unblocked in sync with the light source. This can be used for pump-probe imaging where interaction between charged particle beams and light beam pulses may be controlled capture time-resolved data (e.g., images, video, etc.).The process 1000 may be implemented by some or all components of systems, devices, and/or include processes, methods, or techniques as those described in relation to FIGS. 1-9 and 11-14. In some embodiments, the process 1000 may include more or fewer steps than the number depicted in FIG. 10. It should be appreciated that the steps may be performed in any suitable order. FIG. 10 may occur after synchronization (e.g., phase locking) has occurred as discussed in more detail with respect to FIGS. 8 and 9.

At 1005, a trigger signal may be generated. The beam blanker can be triggered by the blanking signal to rapidly switch between "on" and "off" states, allowing precise control of charged particle beam exposure time on the sample. The trigger signal, which may be a voltage or pulse, is received by the beam blanker.

At 1010, a blanking signal using the trigger signal. The trigger signal, (e.g., a voltage pulse or digital input), may be received and processed by control circuitry of the beam blanker which generates the corresponding blanking signal. This blanking signal may control the operation of the beam blanker by directing the deflection system to divert or block the charged particle beam. The characteristics of the blanking signal including its amplitude, duration, and timing may be derived from the parameters of the trigger signal to provide synchronization.

At 1015, a beam blanker (e.g., beam blanker 155 with respect to FIG. 1) may be modulated. Modulation may occur using the blanking signal. By modulating the timing, duration, and frequency of the trigger signal, the beam blanker can be controlled to achieve synchronized or periodic beam blocking, enabling time-resolved imaging of the sample.

FIG. 11 is an example block flow diagram illustrating example processes 1100 for synchronizing and interrogating charged particle beam pulses and pulsed light beams, in accordance with embodiments of the present disclosure. The process 1100 may be implemented by some or all components of systems, devices, and/or include processes, methods, or techniques as those described in relation to FIGS. 1-10 and 12-14. In some embodiments, the process 1100 may include more or fewer steps than the number depicted in FIG. 11. It should be appreciated that the steps may be performed in any suitable order. FIG. 11 may occur after synchronization (e.g., phase locking) has occurred as discussed in more detail with respect to FIGS. 8 and 9.

At 1102, a first charged particle beam pulse and a second charged particle beam pulse may be generated and may be output from the RF cavity. A high frequency switch (e.g., high frequency switch 431) may receive the first charged particle beam pulse and the second charged particle beam pulse and perform rapid blanking.

At 1104, the first charged particle beam pulse may be blanked based at least in part on an amplified light beam pulse. In some embodiments, the amplified light pulses may be generated at a multiple of the first frequency. In some examples, the multiple of the first frequency is based at least in part on a response time of a sample. According to some embodiments, the high frequency switch that can be coupled with the amplifier of the laser system and/or via a common signal generator configured to generate a trigger signal to the laser amplifier and the high frequency switch. In this way, the beam blanker can be synchronized with a laser amplifier or shutter or have both the pulse picker and the laser amplifier or shutter synchronized to a common trigger signal.

At 1106, the second charged particle beam pulse and the amplified light beam pulse may be directed towards the sample. For example, at least a portion of the charged particle beam pulse may be blanked to generate a subset of the charged particle beam pulses (e.g., 435 as in FIG. 4, 601 as in FIG. 6), at the multiple of the first frequency. Blanking may be performed by the beam blanker (e.g., beam blanker 155 with respect to FIG. 1). The beam blanker may be run at a fixed time delay relative to the RF cavity. The beam blanker may be trigged by a signal from the light source such that the amplified light pulses are time delayed relative to the RF signal pulse, and the beam blanker receives an inverse time delay. In this manner, the timing of the beam blanker may be a constant value relative to the pulses generated in the RF cavity. In some examples, the process may be performed in reverse where the light source may be trigged by a signal from the beam blanker, rather than the beam blanker being triggered by the light source. For example, a shutter on the light source may be controlled by the inverse time delay, triggered by the beam blanker.

In some examples, a delay generator may generate a trigger signal based at least in part on the multiple of the first frequency and transmit the trigger signal to the beam blanker or the optical driver to trigger at least one of the beam blanker or the light source. In addition, or alternatively, transmitting the subset of charged particle beam pulses and the amplified light pulses may include generating, by the delay generator, a time-delayed output to trigger the beam blanker or an amplifier of the light source. In some examples, the time-delayed output may be varied between generation of the subset of charged particle beam pulses and the amplified light pulses while applying an inverse time delay to the light source and the beam blanker and the subset of charged particle beam pulses may be time-shifted relative to the amplified light pulses to compensate for a time delay of the light source with respect to the RF signal.

In some embodiments, generating the trigger signal includes communicating a pulse signal from a pulsed light beam controller to a delay generator. Generating the trigger signal can include receiving a control signal including timing information for the beam blanker and for a pulsed light beam controller. Modulating the beam blanker can include temporarily quenching an electromagnetic field applied by the beam blanker, in the presence of which electrons are deflected away from a beam axis.

In some embodiments, generating the blanking signal includes combining the trigger signal with a delay offset. Generating the blanking signal can include receiving the delay offset from a control system. The delay offset can be an element in a set of offset data. Generating the blanking signal can include selecting the delay offset from the set of offset data in accordance with a process for interrogating a dynamic system.

In some embodiments, the trigger signal is characterized by a frequency from about 0.1 kHz to about ten MHz. The processes 1100 can include synchronizing the pulsed electron beam and the pulsed light beam by operations including synchronizing an RF signal and an optical pulse signal, generating composite signals using the RF signal, the optical pulse signal, and a reference signal, and synchronizing the composite signals.

In some embodiments, modulating the beam blanker temporarily unblocks the pulsed electron beam, permitting one or more pulses of electrons to pass the beam blanker substantially without deflection.

In some embodiments, the process 1100 includes generating a pulse of photons using a pulsed photon source, concurrent with generating the trigger signal. The pulsed light beam can be a pulsed laser. The beam blanker can be an electrostatic beam blanker.

### c. Beam Characterization Processes

Time-resolved imaging relies on capturing phenomena that may evolve on ultrafast timescales (picoseconds or femtoseconds). A temporal pulse profile of the light beam provides information about the timing of excitation events, enabling accurate measurements of the sample's dynamic responses when paired with charged particle beam pulses. A beam intensity and pulse duration of a light source may be adjusted to minimize sample damage caused by excessive energy delivery in sensitive materials. The light beam's temporal pulse profile may influence how photons interact with the sample's electrons, atoms, or molecules.

In addition, the temporal pulse profile helps calibrate the setup, including optical delay lines, trigger synchronization systems, and detectors. Once the light beam's temporal pulse profile is determined, it can be manipulated (e.g., through pulse shaping methods) to provide selective excitation of modes or maximizing signal contrast. The temporal pulse profile may define an intensity variation of the light beam over time, including pulse duration, rise and fall times, and peak intensity (as shown in FIG. 7). The temporal pulse profile may be used for synchronizing the light pulses with the charge particle beam pulses, ensuring that both beams interact with the sample at the desired temporal overlap. In pump-probe experiments, the temporal profile of the light beam may determine how energy is delivered to the sample over time during interrogation. Understanding this temporal pulse profile helps optimize conditions, such as matching the pulse duration of the light beam to the charged particle beam characteristics for energy transfer or dynamic imaging.

FIG. 12 is an example block flow diagram illustrating example processes 1200 for synchronizing and interrogating charged particle beam pulses and pulsed light beams, in accordance with embodiments of the present disclosure. The process 1200 may be implemented by some or all components of systems, devices, and/or include processes, methods, or techniques as those described in relation to FIGS. 1-11, 13, and 14. In some embodiments, the process 1200 may include more or fewer steps than the number depicted in FIG. 12. It should be appreciated that the steps may be performed in any suitable order. The process 1200 can include directing a beam of photons to cross a beam axis 1205 of a charged particle beam system. The process 1200 can include generating a beam of charged particles 1210, the beam being substantially aligned with the beam axis. The process 1200 can include directing the beam of charged particles into an energy-dispersive spectrometer 1215 configured to generate detector data 1220 describing an energy distribution of the beam of charged particles. The process 1200 can also include generating a set of detector data, describing a plurality of energy distributions for a corresponding plurality of timesteps.

In some embodiments, the beam of charged particles is a pulsed beam and the beam of photons is a pulsed beam. The process 1200 can include synchronizing the beam of charged particles with the beam of photons. The process 1200 can also include defining the plurality of timesteps, where a timestep of the plurality of time steps can describe a temporal offset or phase delay of the beam of charged particles relative to the beam of photons.

In some embodiments, the beam of photons includes a pulse of photons defining a temporal profile. The method can include generating profile data using the set of detector data, the profile data describing the temporal profile. Generating the set of detector data can include sampling detector data generated concurrent with a period of interaction of the pulse of photons and the beam of charged particles. The detector data can be characterized by a sampling period about an order of magnitude smaller than a pulse duration described by the temporal profile. The method can include generating an operating parameter scheme corresponding to the temporal profile, the operating parameter scheme describing one or more operating parameters of the charged particle beam system.

In some embodiments, the beam of charged particles includes a pulse of charged particles. Generating the set of detector data can include integrating detector data for a given time step using multiple pulses of charged particles. The charged particles can be electrons. Directing the beam of photons to cross the beam axis can include coupling the beam of photons into an optically conducting material, the material being at least partially transmissive to the charged particles. The material can be disposed at least partially on the beam axis. The optically conducting material can include a photonic nanostructure, microresonator, or a photonic metamaterial.

In some embodiments, the charged particle beam system is an electron microscope. The electron microscope can be a transmission electron microscope (TEM). The electron microscope can include a radio frequency (RF) cavity, configured to generate a pulsed beam of charged particles having a pulse frequency from about twenty-five MHz to about one hundred MHz. Optionally, the pulse frequency can be about seventy-five MHz.

FIG. 13 is an example block flow diagram illustrating example processes 1000 for synchronizing and interrogating charged particle beam pulses and pulsed light beams, in accordance with embodiments of the present disclosure. The process 1000 may be implemented by some or all components of systems, devices, and/or include processes, methods, or techniques as those described in relation to FIGS. 1-9 and 11-14. In some embodiments, the process 1000 may include more or fewer steps than the number depicted in FIG. 10. It should be appreciated that the steps may be performed in any suitable order. FIG. 10 may occur after phase locking has occurred as discussed in more detail with respect to FIGS. 8 and 9.

At 1302, a light beam (e.g., light beam pulses 605 with respect to FIG. 6) may be directed towards a sample (e.g., sample 615 with respect to FIG. 6) within a charged particle column (e.g., charged particle system 100 with respect to FIG. 1). In some examples, the light beam is a pulsed light beam. The light beam may include a temporal profile (and spatial profile).

At 1304, a charged particle beam (e.g., a charged particle beam pulse 415 or a subset of charged particle beam pulses 435 with respect to FIG. 4) may be directed towards the sample. In some examples, the charged particle beam is a charged particle beam pulse.

At 1306, charged particles that interacted with the sample may be detected. An EELS spectrometer (e.g., EELS spectrometer 125 with respect to FIG. 1) may receive the charged particles (e.g., charged particle beam pulse 610 with respect to FIG. 6) and perform an energy loss analysis on the charged particle beam pulse. A relative time delay between the light beam and the charged particle beam may be determined. Determining the time delay may include synchronizing the charged particle beam pulse with the pulsed light beam and determining a plurality of timesteps. A timestep may represents a temporal offset or phase delay of the charged particle beam pulse relative to the pulsed light beam.

According to certain embodiments, determining the relative time delay may include directing the charged particle beam into an energy-dispersive spectrometer (e.g., EELS spectrometer 125) configured to generate detector data describing an energy distribution of the charged particle beam and generating a set of detector data describing a plurality of energy distributions (see FIG. 7) for a corresponding plurality of time steps. Generating the set of detector data may include sampling detector data generated concurrent with a period of interaction of the light beam and the charged particle beam such that the detector data may characterized by a sampling period about an order of magnitude smaller than a pulse duration described by the at least one characteristic, the at least one characteristic being the temporal pulse profile of an intensity of the light beam pulse. Generating the set of detector data may include integrating detector data for a given time step using multiple pulses of charged particles. In addition, or alternatively, profile data using the set of detector data may be generated, the profile data describing the temporal pulse profile (e.g., temporal pulse profile 625 with respect to FIG. 6) of the pulsed light beam.

At 1308, a time delay between the charged particle beam and the light beam pulse may be determined based at least in part on the charged particles. The interaction between the light beam pulse and charged particle beam pulse at the sample may generate measurable signals (e.g., changes in diffraction patterns or induced sample dynamics). In some examples. the delay can be estimated using computational models or algorithms that account for the light beam pulse wavelength and/or charged particle beam pulse duration. According to some embodiments, the light source (e.g., laser oscillator) and the charged particle beam pulse may be synchronized using a trigger signal or independent triggers that are timed relative to each other. The timing of the trigger signals may be used to set a baseline for the arrival times at the sample.

At 1310, at least one characteristic of the light beam may be determined based at least in part on the time delay. The at least one characteristic may include a temporal pulse profile of an intensity of the light beam. In some embodiments, determining the characteristic may include measuring an effective pulse duration of the light beam using PINEM spectra (discussed in more detail with respect to FIG. 6). The characteristic may include, without limitation, a temporal asymmetry of the light beam (as shown in FIG. 7), a pulse duration, and/or a laser chirp. The characterization may be used to characterize one or more optical modes in a microresonator.

### II. Example Control Systems

FIG. 14 is an example block diagram 1400 of a controller 1401 for performing methods, processes, techniques, and similar for a microscope system according to certain aspects of the present disclosure. Examples of the microscope system (e.g., charged particle column) can include some or all components of microscope systems from FIGS. 1-6. Examples of the methods, processes, techniques, operations, can include some or all methods, processes, techniques, operations of FIGS. 7-13. As shown, the controller 1401 may include control circuitry including a processor 1402 communicatively coupled to memory 1404. The processor 1402 can include one processing device or multiple processing devices. Non-limiting examples of the processor 1402 include a Field-Programmable Gate Array (FPGA), an application specific integrated circuit (ASIC), a microprocessor, or any combination of these. The processor 1402 can execute instructions 1410 stored in the memory 1404 to perform operations, such as the operations of microscopes, processes, scans, and methods of FIGS. 1-13. In some examples, the instructions 1410 can include processor-specific instructions generated by a compiler or an interpreter from code written in any suitable computer-programming language, such as C, C++, C#, Python, or Java.

The memory 1404 can include one memory device or multiple memory devices. The memory 1404 can be non-volatile and may include any type of memory device that retains stored information when powered off. Non-limiting examples of the memory 1404 include electrically erasable and programmable read-only memory (EEPROM), flash memory, or any other type of non-volatile memory. At least some of the memory 1404 can include a non-transitory computer-readable medium from which the processor 1402 can read instructions 1410 via bus 1406. The bus 1406 may be a communication and/or power bus that enables processor 1402 to communicate with memory 1404. The non-transitory computer-readable medium can include electronic, optical, magnetic, or other storage devices capable of providing the processor 1402 with the instructions 1410 or other program code. Non-limiting examples of the non-transitory computer-readable medium include magnetic disk(s), memory chip(s), RAM, an ASIC, or any other medium from which a computer processor can read instructions 1410.

The memory 1404 can further include operation information about parameters 1412 (e.g., calibrations, image capture, detector sensitivity, power), RF cavity chopper 1420 (e.g., frequency, synchronization, calibration), image processor 1424 (e.g., dark field, bright field, calibration, intensity, synchronization), light source 1426 (e.g., duty cycle, pulse frequency, synchronization, alignment, calibration), beam blanker 1422 (e.g., frequency, synchronization, calibration), energy filter settings 1428 (e.g., position, adjustments, calibration), and a target stage 1430 (e.g., position, orientation, translations). The controller 1401 can receive the information about operating parameters from a microscope, such as a TEM, SEM, or similar. At least some of the information about any of the controller 1401 components can be pre-stored and can be associated with a various scanning passes (e.g., acquisitions). The parameters 1412 can include operating parameters associated with an electron microscope system, such as a desired energy/primary energy of an electron beam, an energy spread of an energy loss spectrum, lockup mechanisms, feedback loops, etc. In some examples, some of the parameters 1412 can be compared to the predetermined thresholds (e.g., known arrangements, known sample types, etc.).

### DETAILED EXAMPLE EMBODIMENTS

Examples of the inventive subject matter according to the present disclosure are described in the following paragraphs:

According to certain embodiments, a method for mixed signal synchronization for a charged particle column, the method comprising: generating an optical pulse signal from a light source that emits a light beam pulse towards a sample within the charged particle column; generating a radio frequency (RF) signal associated with a RF cavity that pulses a charged particle beam towards the sample; generating a composite signal using at least the RF signal and the optical pulse signal; and controlling, based at least in part on the composite signal, at least one of i) the light source or ii) RF signals for the RF cavity such that light beam pulses and charged particle beam pulses are synchronized at the sample.

The method according to any of the previous examples, the method further comprises generating a first charged particle beam pulse and a second charged particle beam pulse that are output from the RF cavity; blanking, by a beam blanker, based at least in part on an amplified light beam pulse, the first charged particle beam pulse; and directing the second charged particle beam pulse and the amplified light beam pulse towards the sample.

The method according to any of the previous examples, the light source emits the amplified light beam pulse at a frequency, the frequency being based at least in part on a response time of the sample.

The method according to any of the previous examples, the method further comprises generating, by a delay generator, a trigger signal based at least in part on a multiple of the frequency; and transmitting, by the delay generator, the trigger signal to trigger at least one of the beam blanker or the light source.

The method according to any of the previous examples, generating the second charged particle beam pulse and the amplified light pulses further comprises:

The method according to any of the previous examples, the method further comprises generating, by a delay generator, a time-delayed output to trigger the beam blanker or an amplifier of the light source, wherein: the time-delayed output is varied between generation of the second charged particle beam pulse or the amplified light pulse while applying an inverse time delay to the light source or the beam blanker; and the second charged particle beam pulse is time-shifted relative to the amplified light pulses to compensate for a time delay of the light source with respect to the RF signal.

The method according to any of the previous examples, generating the composite signal further comprises: generating an error signal using a harmonic frequency component of the RF signal or a harmonic frequency component of optical pulse signal; and wherein the controlling further comprises: modifying one or more parameters of the RF cavity or light source, as part of an optimization of the error signal.

The method according to any of the previous examples, generating the error signal comprises: generating a vector-product of the RF signal and the optical pulse signal; and filtering the vector-product to remove high frequency components of the vector-product, wherein the high frequency components include harmonic frequencies higher than a fundamental frequency component of the RF signal or the optical pulse signal.

The method according to any of the previous examples, the light source is a pulsed laser source; and the one or more parameters include a characteristic length of a laser oscillator of the light source, the characteristic length describing a path length of the laser oscillator between two reflectors, with one or more of the reflectors being movable relative to a gain medium.

The method according to any of the previous examples, generating the composite signal comprises: generating an RF composite signal, using a vector-product of a harmonic frequency component of the RF signal and a reference signal; and generating an optical composite signal, using a vector-product of a harmonic frequency component of a laser oscillator of the light source and the reference signal, wherein the harmonic frequency component is at least one harmonic order higher than a fundamental frequency of the RF signal or the optical pulse signal.

The method according to any of the previous examples, generating the optical composite signal comprises adding a time delay to the vector-product of the harmonic frequency component of the optical pulse signal and the reference signal.

The method according to any of the previous examples, the reference signal has a frequency from about 5 MHz to about 50 MHz, optionally, the frequency is about 20 MHz.

The method according to any of the previous examples, controlling the optical pulse signals or the RF signals further comprises: switching, at a mode selector, from phase locking at a frequency associated with the optical pulse signal or the RF signal to phase locking at a harmonic frequency of the optical pulse signal or the RF signal.

The method according to any of the previous examples, the method further comprises generating an error signal based at least in part on the composite signal; and modifying one or more parameters of a light source, as part of an optimization of the error signal.

The method according to any of the previous examples, generating the error signal comprises: generating a vector-product of the composite signal; and filtering the vector-product to remove frequency components of the vector-product outside a passband including a harmonic frequency component of the optical pulse signal and a harmonic frequency component of the RF signal.

According to certain embodiments, one or more machine-readable storage media, storing executable instructions that, when executed, cause a charged particle beam column to perform operations comprising: generating an optical pulse signal from a light source that emits a light beam pulse towards a sample within the charged particle column; generating a radio frequency (RF) signal associated with a RF cavity that pulses a charged particle beam towards the sample; generating a composite signal using at least the RF signal and the optical pulse signal; and controlling, based at least in part on the composite signal, at least one of i) the light source or ii) RF signals to control the RF cavity such that light beam pulses and charged particle beam pulses are synchronized at the sample.

The machine-readable storage media or method according to any of the previous examples, the RF cavity is a dual mode cavity.

The machine-readable storage media or method according to any of the previous examples, the operations further comprise: generating, by at least using a pickup antenna of the RF cavity, the RF signal; or receiving, from a RF driver coupled to the RF cavity, the RF signal.

The machine-readable storage media or method according to any of the previous examples, the charged particle beam system is an electron microscope.

A charged particle column comprising: and one or more processors; and one or more machine-readable storage media, operably coupled with control circuitry, the media storing executable instructions that, when executed, cause operations comprising: generating an optical pulse signal for a light source that emits a light beam pulse towards a sample within the charged particle column; generating a radio frequency (RF) signal associated with a RF cavity that pulses a charged particle beam towards the sample; generating a composite signal using at least the RF signal and the optical pulse signal; and controlling, based at least in part on the composite signal, at least one of i) the light source or ii) RF signals to control the RF cavity such that light beam pulses and charged particle beam pulses are synchronized at the sample.

The machine-readable storage media, method, or charged particle column according to any of the previous examples, the charged particle column further comprises a delay generator; and a beam blanker coupled to the delay generator, wherein the delay generator is configured to trigger the beam blanker based at least in part on controlling the light source or the RF cavity.

A method for characterization of a light beam within a charged particle column, the method comprising: directing a light beam pulse towards a sample within the charged particle column; directing a charged particle beam pulse towards the sample; detecting charged particles that, based at least in part on the light beam pulse and the charged particle beam pulse, interacted with the sample; determining a time delay between the charged particle beam pulse and the light beam pulse based at least in part on the charged particles; and determining at least one characteristic of the light beam pulse based at least in part on the time delay.

The machine-readable storage media, method, or charged particle column according to any of the previous examples, wherein the charged particle beam is a charged particle beam pulse, wherein the light beam is a light beam pulse, and wherein determining the time delay further comprises: synchronizing the charged particle beam pulse with the light beam pulse; and determining a plurality of timesteps, wherein a timestep of the plurality of timesteps represents a temporal offset of the charged particle beam pulse relative to the light beam pulse.

The machine-readable storage media, method, or charged particle column according to any of the previous examples, wherein the charged particle beam is a charged particle beam pulse, wherein the light beam is a light beam pulse, and wherein determining the time delay further comprises: synchronizing the charged particle beam pulse with the light beam pulse; and determining a plurality of timesteps, wherein a timestep of the plurality of timesteps represents a phase delay of the charged particle beam pulse relative to the light beam pulse.

The machine-readable storage media, method, or charged particle column according to any of the previous examples, wherein the light beam is a light beam pulse including a temporal pulse profile, the method further comprising: directing the charged particle beam into an energy-dispersive spectrometer configured to generate detector data describing an energy distribution of the charged particle beam; generating a set of detector data describing a plurality of energy distributions for a corresponding plurality of time steps; generating profile data using the set of detector data, the profile data describing the temporal pulse profile.

The machine-readable storage media, method, or charged particle column according to any of the previous examples, wherein generating the set of detector data comprises sampling detector data generated concurrent with a period of interaction of the light beam and the charged particle beam, wherein the detector data is characterized by a sampling period about an order of magnitude smaller than a pulse duration described by the at least one characteristic, the at least one characteristic being the temporal pulse profile of an intensity of the light beam.

The machine-readable storage media, method, or charged particle column according to any of the previous examples, wherein the charged particle beam is a charged particle beam pulse, and wherein generating the set of detector data comprises integrating detector data for a given time step using multiple pulses of charged particles.

The machine-readable storage media, method, or charged particle column according to any of the previous examples, generating an operating parameter scheme corresponding to the at least one characteristic, the operating parameter scheme describing one or more operating parameters of a charged particle beam system, wherein the at least one characteristic includes a temporal pulse profile of an intensity of the light beam.

The machine-readable storage media, method, or charged particle column according to any of the previous examples, wherein determining the at least one characteristic of the light beam further comprises: measuring an effective pulse duration of the light beam using Photon-Induced Near-Field Electron Microscopy (PINEM) spectra.

The machine-readable storage media, method, or charged particle column according to any of the previous examples, further comprising characterizing a temporal intensity distribution of the light beam based at least in part on the effective pulse duration.

One or more machine-readable storage media, storing executable instructions that, when executed, cause a charged particle beam system to perform operations comprising: directing a light beam pulse towards a sample within a charged particle column; directing a charged particle beam pulse towards the sample; detecting charged particles that, based at least in part on the light beam pulse and the charged particle beam pulse, interacted with the sample; determining a time delay between the charged particle beam pulse and the light beam pulse based at least in part on the charged particles; and determining at least one characteristic of the light beam pulse based at least in part on the time delay.

The machine-readable storage media, method, or charged particle column according to any of the previous examples, wherein charged particle column is a transmission electron microscope (TEM).

The machine-readable storage media, method, or charged particle column according to any of the previous examples, wherein the charged particle column includes a radio frequency (RF) cavity configured to generate a charged particle beam pulse.

The machine-readable storage media, method, or charged particle column according to any of the previous examples, wherein a pulse frequency of the charged particle beam pulse is from about 25 MHz to about 100 MHz.

The machine-readable storage media, method, or charged particle column according to any of the previous examples, the operations further comprising: coupling the light beam into an optically conducting material.

The machine-readable storage media, method, or charged particle column according to any of the previous examples, the operations further comprising: adjusting a delay of light beam pulses or charged particle beam pulses towards the sample based at least in part on determining the at least one characteristic.

The machine-readable storage media, method, or charged particle column according to any of the previous examples, the operations further comprising: adjusting an intensity, frequency, or phase delay of the light beam pulses towards the sample based at least in part on determining the at least one characteristic.

A charged particle beam device comprising: one or more processors; and one or more machine-readable storage media, operably coupled with control circuitry, the media storing executable instructions that, when executed, cause operations comprising: directing a light beam pulse towards a sample within the charged particle beam device; directing a charged particle beam pulse towards the sample; detecting charged particles that, based at least in part on the light beam pulse and the charged particle beam pulse, interacted with the sample; determining a time delay between the charged particle beam pulse and the light beam pulse based at least in part on the charged particles; and determining at least one characteristic of the light beam pulse based at least in part on the time delay.

The machine-readable storage media, method, charged particle beam device, or charged particle column according to any of the previous examples, wherein the at least one characteristic of the light beam includes a characterization of a temporal asymmetry of the light beam.

The machine-readable storage media, method, charged particle beam device, or charged particle column according to any of the previous examples, wherein the at least one characteristic of the light beam includes a pulse duration or a laser chirp.

The machine-readable storage media, method, charged particle beam device, or charged particle column according to any of the previous examples, wherein the at least one characterization is used to characterize one or more optical modes in a microresonator

A charged particle beam system may include a source of charged particles, a charged particle beam column, operably coupled with the source of charged particles and including multiple charged particle optical elements disposed along a beam axis, the charged particle optical elements may include a radio-frequency (RF) cavity. In some examples, the system may include a sample section, operably coupled with the charged particle beam column and defining a sample position on the beam axis, a light source, optically coupled with the sample section and may be configured to direct a light beam toward the sample position, and control circuitry, operably coupled with the RF cavity and with the light source, and one or more machine-readable storage media, operably coupled with the control circuitry, the media storing executable instructions that, when executed, cause the system to perform operations including those of the methods or media according to embodiments herein.

A method for synchronizing a charged particle beam pulse with a pulsed light beam, according to any of the previous examples. The method can include synchronizing an RF signal and an optical pulse signal. The method can include generating composite signals using the RF signal, the optical pulse signal, and a reference signal. The method can also include synchronizing the composite signals.

The method according to any of the previous examples, wherein the RF signal describes a frequency generated by an action of an RF cavity on a beam of electrons. The action of the RF cavity on the beam of electrons can include sweeping the beam of electrons across an aperture placed in a path of the beam of electrons. A pulse frequency of the optical pulse signal can be from about 25 MHz to about 125 MHz.

The method according to any of the previous examples, wherein the RF signal and the optical pulse signal are frequency-matched. Frequency matched signals can correspond to a condition wherein a first harmonic frequency of the RF signal is substantially equal to a first harmonic frequency of the optical pulse signal.

The method according to any of the previous examples, further comprising synchronizing the RF signal and the optical pulse signal include generating an error signal using a first harmonic frequency component of the RF signal and a first harmonic frequency component of the optical pulse signal. Synchronizing the RF signal and the optical pulse signal can also include modifying one or more parameters of a pulsed light source, as part of an optimization of the error signal. Generating the error signal can include generating a vector-product of the RF signal and the optical pulse signal and filtering the vector-product to remove high frequency components of the vector-product. The high frequency components can include harmonic frequencies higher than the fundamental frequency component.

The method according to any of the previous examples, wherein the pulsed light source is a pulsed laser source. The one or more parameters can include a characteristic length of a laser oscillator of the pulsed laser source. The characteristic length can describe a path length of the oscillator between two reflectors, with one or more of the reflectors being movable relative to a gain medium.

The method according to any of the previous examples, further comprising generating the composite signals includes generating an RF composite signal, using a vector-product of a harmonic frequency component of the RF signal and the reference signal and generating an optical composite signal, using a vector-product of a harmonic frequency component of the optical pulse signal and the reference signal. The harmonic frequency can refer to a harmonic order higher than the first, or fundamental, frequency. Generating the optical composite signal can include adding a time delay to the vector-product of the harmonic frequency component of the optical pulse signal and the reference signal. The time delay can be a variable time delay.

The method according to any of the previous examples, wherein the reference signal has a frequency from about 5 MHz to about 50 MHz. Optionally, the frequency can be about 20 MHz.

The method according to any of the previous examples, further comprising synchronizing the composite signals includes generating an error signal using the composite signals. Synchronizing the composite signals can also include modifying one or more parameters of a pulsed light source, as part of an optimization of the error signal. Generating the error signal can include generating a vector-product of the RF composite signal and the optical composite signal and filtering the vector-product to remove frequency components of the vector-product outside a passband including the harmonic frequency component of the optical pulse signal and the harmonic frequency component of the RF composite signal.

One or more machine-readable storage media store executable instructions that, when executed by a machine, cause the machine to perform operations including those of the methods according to any of the previous examples.

A charged particle beam system includes a source of charged particles. The system includes a charged particle beam column, operably coupled with the source of charged particles and including multiple charged particle optical elements disposed along a beam axis, the charged particle optical elements including a radio-frequency (RF) cavity. The system includes a sample section, operably coupled with the charged particle beam column and defining a sample position on the beam axis. The system includes a light source, optically coupled with the sample section and configured to direct a light beam toward the sample position. The system includes control circuitry, operably coupled with the RF cavity and with the light source. The system can also include one or more machine-readable storage media, operably coupled with the control circuitry, the media storing executable instructions that, when executed, cause the system to perform operations including those of the methods of the first aspect in one or more embodiments.

The system according to any of the previous examples, wherein the RF cavity is a dual mode cavity. The RF cavity can include a pickup antenna. The charged particle beam system can include an electron microscope. The electron microscope can be a transmission electron microscope (TEM).

A method for synchronizing a charged particle beam pulse with a pulsed light beam. The method can include generating a trigger signal. The method can include generating a blanking signal using the trigger signal. The method can also include modulating a beam blanker using the blanking signal.

The method according to any of the previous examples, further comprising generating the trigger signal includes communicating a pulse signal from a pulsed light beam controller to a delay generator. Generating the trigger signal can include receiving a control signal including timing information for the beam blanker and for a pulsed light beam controller. Modulating the beam blanker can include temporarily quenching an electromagnetic field applied by the beam blanker, in the presence of which electrons are deflected away from a beam axis.

The method according to any of the previous examples, further comprising generating the blanking signal includes combining the trigger signal with a delay offset. Generating the blanking signal can include receiving the delay offset from a control system. The delay offset can be an element in a set of offset data. Generating the blanking signal can include selecting the delay offset from the set of offset data in accordance with a process for interrogating a dynamic system.

The method according to any of the previous examples, wherein the trigger signal is characterized by a frequency from about 0.1 kHz to about ten MHz. The method can include synchronizing the charged particle beam pulse and the pulsed light beam by operations including synchronizing an RF signal and an optical pulse signal, generating composite signals using the RF signal, the optical pulse signal, and a reference signal, and synchronizing the composite signals.

The method according to any of the previous examples, wherein modulating the beam blanker temporarily unblocks the charged particle beam pulse, permitting one or more pulses of electrons to pass the beam blanker substantially without deflection.

The method according to any of the previous examples, further comprising generating a pulse of photons using a pulsed light source, concurrent with generating the trigger signal. The pulsed light beam can be a pulsed laser. The beam blanker can be an electrostatic beam blanker.

One or more machine-readable storage media, storing executable instructions that, when executed by a machine, cause the machine to perform operations including those of the methods according to any of the previous examples.

A charged particle beam system, may include a source of charged particles. The system includes a charged particle beam column, operably coupled with the source of charged particles and including multiple charged particle optical elements disposed along a beam axis, the charged particle optical elements including a radio-frequency (RF) cavity and a beam blanker. The system includes a sample section, operably coupled with the charged particle beam column and defining a sample position on the beam axis. The system includes a light source, optically coupled with the sample section and configured to direct a light beam toward the sample position. The system includes control circuitry, operably coupled with the RF cavity and with the light source. The system can also include one or more machine-readable storage media, operably coupled with the control circuitry, the media storing executable instructions that, when executed, cause the system to perform operations including those of the methods of the fourth aspect in one or more embodiments.

The system according to any of the previous examples, wherein the charged particle beam system is an electron microscope. The electron microscope can be a transmission electron microscope (TEM). The beam blanker can be an electrostatic beam blanker.

A method for sampling a pulsed light beam comprising directing a light beam to cross a beam axis of a charged particle beam system. The method can include generating a charged particle beam, the beam being substantially aligned with the beam axis. The method can include directing the charged particle beam into an energy-dispersive spectrometer configured to generate detector data describing an energy distribution of the charged particle beam. The method can also include generating a set of detector data, describing a plurality of energy distributions for a corresponding plurality of timesteps.

The method according to any of the previous examples, wherein the charged particle beam is a pulsed beam and the light beam is a pulsed beam. The method can include synchronizing the charged particle beam with the light beam. The method can also include defining the plurality of timesteps, where a timestep of the plurality of time steps can describe a temporal offset or phase delay of the charged particle beam relative to the light beam.

The method according to any of the previous examples, wherein the light beam includes a pulse of photons defining a temporal profile. The method can include generating profile data using the set of detector data, the profile data describing the temporal profile. Generating the set of detector data can include sampling detector data generated concurrent with a period of interaction of the pulse of photons and the charged particle beam. The detector data can be characterized by a sampling period about an order of magnitude smaller than a pulse duration described by the temporal profile. The method can include generating an operating parameter scheme corresponding to the temporal profile, the operating parameter scheme describing one or more operating parameters of the charged particle beam system.

The method according to any of the previous examples, wherein the charged particle beam includes a pulse of charged particles. Generating the set of detector data can include integrating detector data for a given time step using multiple pulses of charged particles. The charged particles can be electrons. Directing the light beam to cross the beam axis can include coupling the light beam into an optically conducting material, the material being at least partially transmissive to the charged particles. The material can be disposed at least partially on the beam axis. The optically conducting material can include a photonic nanostructure, microresonator, or a photonic metamaterial.

The method according to any of the previous examples, wherein the charged particle beam system is an electron microscope. The electron microscope can be a transmission electron microscope (TEM). The electron microscope can include a radio frequency (RF) cavity, configured to generate a charged particle beam pulse having a pulse frequency from about twenty-five MHz to about one hundred MHz. Optionally, the pulse frequency can be about seventy-five MHz.

One or more machine-readable storage media, storing executable instructions that, when executed by a machine, cause the machine to perform operations including those of the method according to any of the previous examples.

A charged particle beam system comprises a source of charged particles. The system includes a charged particle beam column, operably coupled with the source of charged particles and including multiple charged particle optical elements disposed along a beam axis, the charged particle optical elements including a radio-frequency (RF) cavity and a beam blanker. The system includes a sample section, operably coupled with the charged particle beam column and defining a sample position on the beam axis. The system includes a light source, optically coupled with the sample section and configured to direct a light beam toward the sample position. The system includes control circuitry, operably coupled with the RF cavity and with the light source. The system can also include one or more machine-readable storage media, operably coupled with the control circuitry, the media storing executable instructions that, when executed, cause the system to perform operations including those of the methods of the seventh aspect in one or more embodiments.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on ultrafast charged particle beam systems, and ultrafast TEM (or UTEM) systems in particular, these are meant as non-limiting, illustrative embodiments. Embodiments of the present disclosure are not limited to such embodiments, but rather are intended to address analytical instruments systems for which a wide array of material samples can be analyzed to determine chemical, biological, physical, structural, or other properties, among other aspects, including but not limited to chemical structure, trace element composition, or the like, that exhibit temporal dynamics on the sub-microsecond timescale.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on electron microscopy systems, these are meant as non-limiting, illustrative embodiments. Embodiments of the present disclosure are not limited to such materials, but rather are intended to address electron beam systems for which a wide array of particles can be applied to imaging, microanalysis, and/or processing of materials on an atomic scale. Such particles may include, but are not limited to, electrons, ions, or photons in TEM systems, SEM systems, STEM systems, UFTEM systems, EFTEM systems, ion beam systems, and/or particle accelerator systems.

Some embodiments of the present disclosure include a system including one or more data processors and/or logic circuits. In some embodiments, the system includes a non-transitory computer readable storage medium containing instructions which, when executed on the one or more data processors, cause the one or more data processors to perform part or all of one or more methods and/or part or all of one or more processes and workflows disclosed herein. Some embodiments of the present disclosure include a computer-program product tangibly embodied in a non-transitory machine-readable storage medium, including instructions configured to cause one or more data processors to perform part or all of one or more methods and/or part or all of one or more processes disclosed herein, including, for example, methods, operations, processes of FIG. 5, 7-10, 13-15, and 20-25.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

As used in this application and in the claims, the singular forms "a", "an", and "the" include the plural forms unless the context clearly dictates otherwise. Additionally, the term "includes" means "comprises". Further, the term "coupled" does not exclude the presence of intermediate elements between the coupled items.

The systems, apparatuses, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatuses are not limited to any specific aspect or feature or combinations thereof, nor do the disclosed systems, methods, and apparatuses require that any one or more specific advantages be present or problems be solved. Any theories of operation are to facilitate explanation, but the disclosed systems, methods, and apparatuses are not limited to such theories of operation.

Although the operations of some of the disclosed methods are described in a particular, sequential order for convenient presentation, it should be understood that this manner of description encompasses rearrangement, unless a particular ordering is required by specific language. For example, operations described sequentially may in some cases be rearranged or performed concurrently. Moreover, for the sake of simplicity, the attached figures may not show the various ways in which the disclosed systems, methods, and apparatuses can be used in conjunction with other systems, methods, and apparatuses. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one or ordinary skill in the art.

In some examples, values, procedures, or apparatuses are referred to as "lowest", "best", "minimum", "greater", "less than", "equal to" or the like. It will be appreciated that such descriptions are intended to indicate that a selection among many used functional alternatives can be made, and such selections need not be better, smaller, or otherwise preferable to other selections.

The term "image" is intended to comprise a two-dimensional grid, wherein the two-dimensional grid can comprise at least one or a plurality of portions. Each portion is characterized by its coordinates and its value (color and/or intensity). Thus, the image may refer to a visual representation of the sample in gray level variations and/or color variations and/or intensity variations. Further, each portion in the image may correspond to a point (e.g. location) on the target or a sublocation on the target, or similar.

Some embodiments of the present disclosure include a system including one or more data processors and/or logic circuits. In some embodiments, the system includes a non-transitory computer readable storage medium containing instructions which, when executed on the one or more data processors and/or logic circuits, cause the one or more data processors and/or logic circuits to perform part or all of one or more methods and/or part or all of one or more processes and workflows disclosed herein. Some embodiments of the present disclosure include a computer-program product tangibly embodied in non-transitory machine-readable storage media, including instructions configured to cause one or more data processors and/or logic circuits to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property within which the deviation has little to no influence of the corresponding function, property, or attribute of the structure being described. In an illustrated example, where a dimensional parameter is described as "substantially equal" to another dimensional parameter, the term "substantially" is intended to reflect that the two parameters being compared can be unequal within a tolerable limit, such as a fabrication tolerance or a confidence interval inherent to the operation of the system. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For numerical values, such as diameters, lengths, widths, or the like, the term "about" can be understood to describe a deviation from the stated value of up to ±20%. For example, a dimension of "about 20 mm" can describe a dimension from fifteen mm to twenty five mm.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims. Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

## Claims

1. A method for characterization of a light beam within a charged particle column, the method comprising:
directing a light beam pulse towards a sample within the charged particle column;
directing a charged particle beam pulse towards the sample;
detecting charged particles that, based at least in part on the light beam pulse and the charged particle beam pulse, interacted with the sample;
determining a time delay between the charged particle beam pulse and the light beam pulse based at least in part on the charged particles; and
determining at least one characteristic of the light beam pulse based at least in part on the time delay.

2. The method of claim 1, wherein the charged particle beam is a charged particle beam pulse, wherein the light beam is a light beam pulse, and wherein determining the time delay further comprises:
synchronizing the charged particle beam pulse with the light beam pulse; and
determining a plurality of timesteps, wherein a timestep of the plurality of timesteps represents a temporal offset or a phase delay of the charged particle beam pulse relative to the light beam pulse.

3. The method of claim 1, wherein the light beam is a light beam pulse including a temporal pulse profile, the method further comprising:
directing the charged particle beam into an energy-dispersive spectrometer configured to generate detector data describing an energy distribution of the charged particle beam;
generating a set of detector data describing a plurality of energy distributions for a corresponding plurality of time steps; and
generating profile data using the set of detector data, the profile data describing the temporal pulse profile.

4. The method of claim 3, wherein generating the set of detector data comprises sampling detector data generated concurrent with a period of interaction of the light beam and the charged particle beam, wherein the detector data is **characterized by** a sampling period about an order of magnitude smaller than a pulse duration described by the at least one characteristic, the at least one characteristic being the temporal pulse profile of an intensity of the light beam.

5. The method of claim 3, wherein the charged particle beam is a charged particle beam pulse, and wherein generating the set of detector data comprises integrating detector data for a given time step using multiple pulses of charged particles.

6. The method of claim 1, further comprising:
generating an operating parameter scheme corresponding to the at least one characteristic, the operating parameter scheme describing one or more operating parameters of a charged particle beam system, wherein the at least one characteristic includes a temporal pulse profile of an intensity of the light beam.

7. The method of claim 1, wherein determining the at least one characteristic of the light beam further comprises, measuring an effective pulse duration of the light beam using Photon-Induced Near-Field Electron Microscopy (PINEM) spectra, the method further comprising
characterizing a temporal intensity distribution of the light beam based at least in part on the effective pulse duration.

8. One or more machine-readable storage media, storing executable instructions that, when executed, cause a charged particle beam system to perform operations comprising:
directing a light beam pulse towards a sample within a charged particle column;
directing a charged particle beam pulse towards the sample;
detecting charged particles that, based at least in part on the light beam pulse and the charged particle beam pulse, interacted with the sample;
determining a time delay between the charged particle beam pulse and the light beam pulse based at least in part on the charged particles; and
determining at least one characteristic of the light beam pulse based at least in part on the time delay.

9. The one or more machine-readable storage media of claim 8, wherein the charged particle column includes a radio frequency (RF) cavity configured to generate a charged particle beam pulse.

10. The one or more machine-readable storage media of claim 8, the operations further comprising coupling the light beam into an optically conducting material.

11. The one or more machine-readable storage media of claim 8, the operations further comprising adjusting a delay of light beam pulses or charged particle beam pulses towards the sample based at least in part on determining the at least one characteristic.

12. The one or more machine-readable storage media of claim 11, the operations further comprising:
adjusting an intensity, frequency, or phase delay of the light beam pulses towards the sample based at least in part on determining the at least one characteristic.

13. A charged particle beam device comprising:
one or more processors; and
one or more machine-readable storage media, operably coupled with control circuitry, the media storing executable instructions that, when executed, cause operations comprising:
directing a light beam pulse towards a sample within the charged particle beam device;
directing a charged particle beam pulse towards the sample;
detecting charged particles that, based at least in part on the light beam pulse and the charged particle beam pulse, interacted with the sample;
determining a time delay between the charged particle beam pulse and the light beam pulse based at least in part on the charged particles; and
determining at least one characteristic of the light beam pulse based at least in part on the time delay.

14. The charged particle beam device of claim 13, wherein the at least one characteristic of the light beam includes a characterization of a temporal asymmetry of the light beam.

15. The charged particle beam device of claim 13, wherein the at least one characteristic of the light beam includes a pulse duration or a laser chirp.
